# EUROPEAN PATENT SPECIFICATION

(11) **EP 2 735 624 B1**
(45) Date of publication and mention of the grant of the patent: **01.08.2018**
(21) Application number: 12815216.2
(22) Date of filing: 18.06.2012
(51) Int. Cl.: C23C 16/26, C23C 16/02, C23C 16/46, C23C 16/04

(54) **METHOD FOR FORMING DIAMOND-LIKE CARBON FILM ON METAL SUBSTRATES**
VERFAHREN ZUR HERSTELLUNG EINES DIAMANTARTIGEN KOHLENSTOFFFILMS AUF METALLSUBSTRATEN
PROCÉDÉ DE FORMATION D'UN FILM DE CARBONE DU TYPE DIAMANT SUR UN SUBSTRAT MÉTALLIQUE

(30) Priority: 21.07.2011 JP 2011160258; 06.04.2012 JP 2012087395
(43) Date of publication of application: 28.05.2014
(73) Proprietor: The University of Electro-Communications, Chofu-shi Tokyo 182-8585 (JP)
(72) Inventor: TANAKA, Katsumi, Chofu-shi Tokyo 182-8585 (JP); CHOO, Cheow Keong, Chofu-shi Tokyo 182-8585 (JP)
(74) Representative: Hoffmann Eitle
(86) International application number: PCT/JP2012/065527
(87) International publication number: WO 2013/011784

(56) References cited:
- JP-A- 9 012 397
- JP-A- 62 047 480
- JP-A- 63 026 371
- JP-A- 2008 063 607
- JP-A- 2008 260 670
- US-A1- 2007 141 256
- US-A1- 2010 239 854

## Description

### TECHNICAL FIELD

The invention relates to a metal film with diamond-like carbon film which includes a diamond-like carbon film formed on metal and a method of forming a diamond-like carbon film.

### BACKGROUND ART

Diamond-like carbon (hereinafter, also referred to as DLC), which is in practical use mainly as hard coating materials of tools, is widely known to be produced at low temperature using plasma CVD (chemical vapor deposition) apparatuses.

However, the plasma CVD apparatuses have drawbacks of complex structure itself and high apparatus introduction cost.

On the other hand, apparatuses producing DLC film using thermal CVD have a simple structure and can be introduced at low cost (see Patent Literatures 1 and 2, for example).

### CITATION LIST

### PATENT LITERATURE

Patent Literature 1: Japanese Patent Application Publication No. 2005-226162
Patent Literature 2: Japanese Patent Application Publication No. 2008-260670
Patent Literature 3: US 2010/0239854 A1
Patent Literature 4: US 2007/0141256 A1

### SUMMARY OF INVENTION

### PROBLEMS TO BE SOLVED BY INVENTION

However, in Patent Literature 1, the process needs to be performed at high temperatures of 1400°C or higher. The objects on which film is to be formed are substrates made of non-metal such as semiconductor materials in terms of the resistance to high temperature. The process of Patent Literature 1 employs a catalytic solution, and accordingly, the produced DLC film does not have very high adhesion.

In Patent Literature 2, the process does not use a catalyst. The adhesion of the produced DLC film is higher than that in Patent Literature 1. However, the objects on which film is to be formed are usually substrates made of non-metal such as semiconductor materials because film formation is performed at high temperatures of 1000°C or higher.

Accordingly, if DLC film can be formed at a temperature lower than those of the conventional methods by using a thermal CVD apparatus which can be introduced at low cost, that is preferable, the DLC film can be easily formed on metal and can be used in a wider range of industrial applications.

Patent Literature 3 discloses an example of preparation of a metallic material with carbon film. In this example, a metal substrate of AISI 304 stainless steel was placed in a thermal CVD furnace, then reduced and activated at 850° C. under 1 atm of hydrogen. After the furnace was cooled down to 700° C., a gas mixture of methane and hydrogen (methane concentration: 80% by volume) was fed into the furnace. The furnace was held at 700° C. for 60 minutes to form a diffusion layer on the stainless steel substrate and an amorphous layer on the diffusion layer. The furnace was then raised to 950° C. with a heating rate of 20° C./min and held for 10 minutes to form a graphite-like layer on the amorphous layer.

Patent Literature 4 describes a method for depositing a layer containing carbon on a Si substrate. According to one embodiment of this method, during the temperature ramp-up phase of the processing chamber, from, e.g., room temperature to, e.g. about 840 °C, in case of Ar/C₂H₂ for example with a ratio of flow 5/1, the carbon containing gas C₂H₂ may decompose at temperatures above 305 °C to undefined polymers which may deposit and form a uniform carbon containing layer over the surface of the silicon substrate.

The invention has been made in the light of the aforementioned problems, and an object of the invention is to provide a metal object with diamond-like carbon film in which diamond-like carbon film is easily formed on metal and a method of forming the diamond-like carbon film.

### MEANS FOR SOLVING THE PROBLEM

To achieve the aforementioned object, a metal object with diamond-like carbon film according to the present disclosure, but not according to the presently claimed invention, includes: a metallic film formation target as an object on which a diamond-like carbon film is to be formed; and a diamond-like carbon film which is formed on a film formation target surface of the film formation target by placing the film formation target in a flow channel through which film formation gas containing methane gas flows; and causing the film formation gas to flow through the flow channel at a predetermined flow rate during a process of raising the temperature of the film formation target from room temperature to a predetermined temperature to allow the film formation gas to react with impurities in the film formation target surface for removal of the impurities from the film formation target surface and further to allow the film formation gas to react with a metallic element exposed by the removal of impurities.

Moreover, a method of forming a diamond-like carbon film according to the present invention includes: a placement step of placing a metallic film formation target on which a diamond-like carbon film is to be formed in a flow channel through which film formation gas containing methane gas and argon gas supplied from a gas source is caused to flow; and an impurity removal/film formation step of forming the diamond-like carbon film on a film formation target surface of the film formation target by causing the film formation gas from the gas source to flow through the flow channel at a predetermined flow rate during a process of raising the temperature of the film formation target from room temperature to a predetermined temperature to allow the film formation gas to react with impurities in the film formation target surface for removal of the impurities from the film formation target surface and further to allow the film formation gas to react with a metallic element exposed by the removal of impurities, wherein the method is carried out in a film formation apparatus comprising the gas source including a methane gas source and an argon gas source; the flow channel provided with a furnace; and a controller controlling the gas source and the flow channel, wherein the controller includes a gas controller, which is configured to control the mixing ratio of the methane gas to the argon gas and regulate the flow rate of the film formation gas, and a temperature controller, which is configured to control the temperature of the film formation gas.

### EFFECTS OF INVENTION

According to the metal object with diamond-like carbon film according to the present disclosure, but not according to the presently claimed invention, it is possible to easily implement an object including a diamond-like carbon film with high adhesion and high hardness on the film formation target surface of the metal object.

Moreover, according to the method for forming a diamond-like carbon film of the present invention, DLC film can be formed at lower temperature than that of the conventional methods. It is therefore possible to easily form a diamond-like carbon film having high adhesion and high hardness on metal.

### BRIEF DESCRIPTION OF DRAWINGS

[Fig. 1] Fig. 1(a) is a schematic view explaining the concept of a film formation apparatus and Fig. 1(b) is a cross-sectional view illustrating formation of DLC film in a first embodiment.
[Fig. 2] Fig. 2(a) is a schematic view explaining the concept of a film formation apparatus and Fig. 2(b) is a cross-sectional view illustrating formation of DLC film in a second embodiment.
[Fig. 3] Fig. 3 is an explanatory diagram showing names, usage examples and applications, and JIS standards of steels used in Experimental Example 1.
[Fig. 4] Fig. 4 is an explanatory diagram showing small amounts of elements contained in each steel and the proportions thereof in Experimental Example 1.
[Fig. 5] Fig. 5(a) is an explanatory view of horizontal placement of substrates and Fig. 5(b) is an explanatory view of vertical placement of a substrate in Experimental Example 1.
[Fig. 6] Fig. 6 is a graph explaining a first temperature process in Experimental Example 1.
[Fig. 7] Fig. 7 is a graph explaining a second temperature process in Experimental Example 1.
[Fig. 8] Fig. 8 is a graph explaining a third temperature process in Experimental Example 1.
[Fig. 9] Fig. 9 is an explanatory diagram showing the results of evaluation of diamond-like carbon films produced in Experimental Example 1.
[Fig. 10] Fig. 10 is a chart showing a Raman spectrum obtained by performing Raman spectroscopy for a diamond-like carbon film in Experimental Example 2.
[Fig. 11] Fig. 11 is a chart explaining a difference in Raman spectrum depending on crystallinities of carbon materials in Experimental Example 2.
[Fig. 12] Fig. 12 is a diagram including photographs showing indentations by micro-Vickers tests in Experimental Example 3.
[Fig. 13] Fig. 13 is a graph showing frictional coefficients of diamond-like carbon films measured in Experimental Example 4.
[Fig. 14] Fig. 14 is a graph showing frictional coefficients of diamond-like carbon films measured in Experimental Example 4.
[Fig. 15] Fig. 15 is a graph showing frictional coefficients of diamond-like carbon films (made by another company) measured in Experimental Example 4.
[Fig. 16] Fig. 16 is a diagram including a photograph of traces on the diamond-like carbon film in Experimental Example 4.
[Fig. 17] Fig. 17 is a diagram including a photograph of traces on the diamond-like carbon film in Experimental Example 4.
[Fig. 18] Fig. 18(a) to Fig. 18(c) are graphs illustrating results of nano-indentation tests performed for diamond-like carbon films in Experimental Example 5.
[Fig. 19] Fig. 19(a) to Fig. 19(c) are graphs illustrating results of nano-indentation tests performed for diamond-like carbon films (made by another company) in Experimental Example 5.
[Fig. 20] Fig. 20 is a graph showing the measurement results of Vickers hardness and Young's modulus of diamond-like carbon films in Experimental Example 5.
[Fig. 21] Fig. 21(a) is a diagram including a photograph of the interface between a diamond-like carbon film and a metallic substrate in Experimental Example 6 and Fig. 21(b) is a partial enlargement view of Fig. 21(a).
[Fig. 22] Fig. 22(a) is a chart obtained by an elemental analysis for the diamond-like carbon film, Fig. 22(b) is a chart obtained by an elemental analysis for the interface between the diamond-like carbon film and metallic substrate, and Fig. 22(c) is a chart obtained by an elemental analysis for the metallic substrate in Experimental Example 6.
[Fig. 23] Fig. 23 is a graph explaining the relationship between the temperature and time in the process of raising the temperature in Experimental Example 7.
[Fig. 24] Fig. 24 is a graph explaining the relationship between the temperature and time in the process of raising the temperature in Experimental Example 7.
[Fig. 25] Fig. 25 is a diagram including photographs of cross-sections of samples in Experimental Example 7.
[Fig. 26] Fig. 26 is a diagram including photographs of cross-sections of samples in Experimental Example 7.
[Fig. 27] Fig. 27 is a diagram including photographs of cross-sections of samples in Experimental Example 7.
[Fig. 28] Fig. 28 is a diagram including photographs of cross-sections of samples in Experimental Example 7.
[Fig. 29] Fig. 29 is an explanatory diagram explaining examination results in Experimental Example 7.
[Fig. 30] Fig. 30 is a chart showing measurement results of changes in hardness in the depth direction from the outermost surfaces of diamond-like carbon films in Experimental Example 7.
[Fig. 31] Fig. 31(a) is a schematic view explaining the concept of a film formation apparatus used in a third embodiment and
Fig. 31(b) a cross-sectional view illustrating formation of DLC film.
[Fig. 32] Fig. 32 is an explanatory diagram showing the relationship between the distance from the central part of an electric furnace on the downstream side and the temperature at the same distance in Experimental Example 8.
[Fig. 33] Fig. 33 is an explanatory diagram showing film formation conditions in Experimental Example 8.
[Fig. 34] Fig. 34(a) and Fig. 34(b) are explanatory views explaining base materials in Experimental Example 8.
[Fig. 35] Fig. 35(a) to Fig. 35(c) are charts respectively obtained by Raman spectroscopy performed for films formed in samples A to C in Experimental Example 8.
[Fig. 36] Fig. 36(d) to Fig. 36(g) are charts respectively obtained by Raman spectroscopy performed for films formed in samples D to G in Experimental Example 8.

### MODES FOR CARRYING OUT THE INVENTION

Hereinafter, a description is given of embodiments of the invention with reference to the drawings. In the following description, the same or similar constituent elements to ones previously described are given same or similar referential numerals, and the detailed description thereof properly omitted.

It is noted that the drawings are schematic and some dimensional proportions are different from real ones. Accordingly, specific dimensional ratios and the like should be determined with reference to the following description. Moreover, it is certain that some portions have different dimensional relationships and proportions in different drawings.

Moreover, the embodiments shown in the drawings are just shown by way of example for embodying the technical idea of the invention. In the embodiments of the invention, the materials, shapes, structures, arrangements, and the like of the constituent components are not specified to the followings. The embodiments of the invention can be variously changed without departing from the scope thereof to be implemented.

### [First Embodiment]

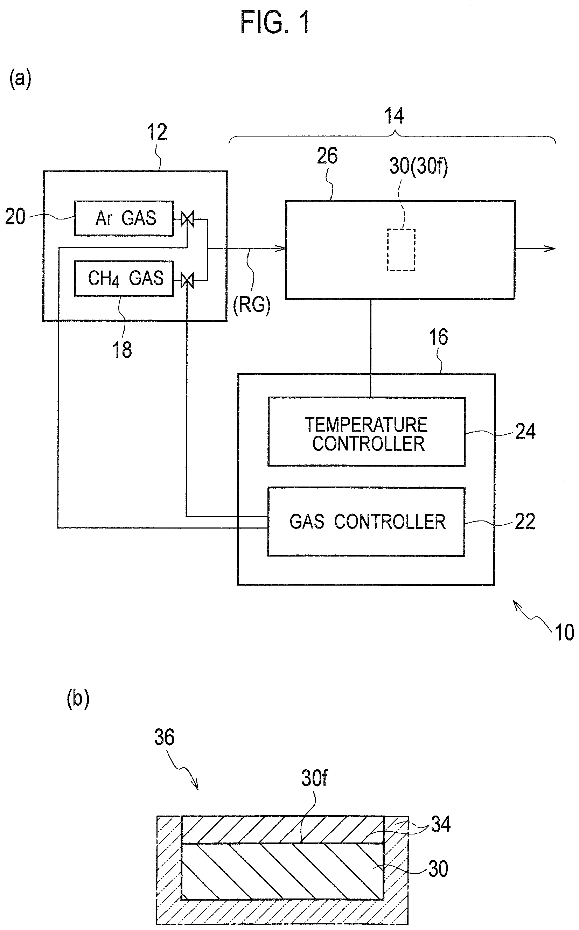

First, a description is given of a first embodiment. Fig. 1(a) is a schematic view explaining the concept of a film formation apparatus used in the first embodiment, and Fig. 1(b) is a cross-sectional view illustrating formation of DLC film.

As illustrated in Fig. 1(a), a film formation apparatus 10 used in the first embodiment includes: a gas source 12; a flow channel 14 through which gas supplied from the gas source 12 flows; and a controller 16 controlling the gas source 12 and flow channel 14.

The gas source 12 includes a methane gas (CH₄ gas) source 18 and an argon gas (Ar gas) source 20. The flow channel 14 is provided with a furnace on which a film formation target is placed. The controller 16 includes a gas controller 22 and a temperature controller 24. The gas controller 22 is configured to control the mixing ratio of methane gas to argon gas (for example, the mixing ratio of methane gas to argon gas is controlled to 1/9) and regulate the flow rate of film formation gas RG which is the mixture of methane gas and argon gas. The temperature controller 24 is configured to control the temperature of film formation gas.

### (Placement Step)

In the first embodiment, the furnace provided for the flow channel 14 is a commercially available electric furnace 26 such as a muffle furnace, for example. A metallic film formation target 30 as an object on which a diamond-like carbon film (DLC film) is to be formed is placed in the electric furnace 26.

Examples of the metallic film formation target 30 are metal objects (metallic members, parts, and the like) of SKD11, S45C, SKH51, SNCM439, SUS304, and SCM440. SKD11 is suitable for use in drill rods, and SKH51 is suitable for use in high-speed steel. SCM440 is chromium molybdenum steel and is suitable for use as structural steel. S45C is suitable for use as steel pipes.

### (Impurity removal/film formation step)

After the film formation target 30 is placed, the film formation gas RG is caused to flow through the flow channel 14, and during a process of heating the substrate 30 from room temperature to a predetermined temperature in the electric furnace 26 and a process of heating the gas within the electric furnace 26 from room temperature to the predetermined temperature. At the process of heating, it is preferable that heating is started after the gas (air) in the flow channel 14 is replaced with the film formation gas RG. This can avoid reaction between methane gas and oxygen contained in the air inside the flow channel 14 during the process of heating.

By increasing the temperature of the substrate 30 to the predetermined temperature while bringing methane gas into contact with the film formation target surface in such a manner, the film formation gas RG reacts with impurities such as oxides in the film formation target surface 30f into gas form such as H₂O and CO₂, so that the impurities are removed from the film formation target surface 30f. Furthermore, metal elements in the film formation target surface 30f exposed by removing impurities react with the film formation gas RG, thus forming a DLC film 34 (see Fig. 1(b)) on the film formation target surface.

The upper limit of the predetermined temperature is the highest temperature at which the film formation target 30 does not melt with heat. It is preferable that the predetermined temperature is as low as possible so that the apparatus configuration of the film formation apparatus be simplified. In the first embodiment, the film formation target is a metallic plate. Impurities on the plate are removed to expose elements of the metal of the plate, so that film can be well formed even if the gas temperature is set lower than that in the case of using a semiconductor substrate such as a silicon wafer. Accordingly, compared with the case where the film formation target is a semiconductor substrate, even if the gas temperature is lowered to about 900°C, the film formation has no problem in film formation speed. Even if the gas temperature is 850°C, the film formation speed is not reduced significantly, and the apparatus configuration can be further simplified. Moreover, even if the gas temperature is 800°C, DLC film can be formed at adequate film formation speed, and the apparatus configuration can be still further simplified. Even if the gas temperature is 750°C, DLC film can be formed at moderate film formation speed, and the apparatus configuration can be still further simplified.

The lower limit of the predetermined temperature is a temperature at which the DLC film 34 is formed on the film formation target 30 at a problem-free film formation speed. Practically, the lower limit can be reduced to about 400°C.

In the aforementioned steps, applying the film formation gas RG at atmospheric pressure prevents air from the outside of the film formation apparatus 10 from being mixed into the flow channel 14, even if the flow channel 14 does not have a structure resistant to pressure reduction (such a structure that can prevent external air from entering the same). Alternatively, the pressure of the film formation gas RG flowing in the flow channel 14 may be set higher than the atmospheric pressure so that the film formation speed be increased. In such a case, the apparatus needs to have a pressure-resistant structure so as to prevent leakage of the film formation gas RG from the flow channel 14 to the outside.

After the film formation step is completed, the electric furnace 26 is released, and the film formation target 30 is taken out of the electric furnace 26. At the end of the film formation step, preferably, inert or nitrogen gas is caused to flow through the flow channel 14 to remove methane gas, and the film formation gas and film formation target 30 within the electric furnace 26 are cooled to room temperature. The electric furnace 26 is then released. This prevents formation of soot on the DLC film 34 formed on the film formation target 30. Even if soot is formed thereon, the soot can be wiped out.

According to the first embodiment, the DLC film 34 can be formed on the metallic film formation target 30 with a simple method at low cost. Moreover, the DLC film 34 is formed by using a pyrolytic reaction of the film formation gas on the surface of the film formation target surface which is in contact with the film formation gas. Accordingly, the DLC film 34 can be formed on fine irregularities (protrusions and recesses) and can be simultaneously formed on the entire surface, including the side and rear surfaces, of the film formation target surface 30f or the inside and outside of a tube, which is impossible with the conventional plasma CVD. Since the thus-formed DLC film 34 is formed with a hydrocarbon pyrolysis process, both the G and D peaks (described later) are prominently observed by Raman scattering spectroscopy. On the other hand, in the DLC film manufactured by a plasma process, the G peak is observed strongly while the D peak is observed as a shoulder. Accordingly, it can be distinguished whether the DLC film was formed by hydrocarbon pyrolysis or plasma processes.

Moreover, for the commercially-available electric furnace 26 is applicable, DLC film can be formed even if the film formation target has a larger size than that in the case of film formation using a plasma CVD apparatus or the like.

Moreover, selection of an iron-based metallic material and a film formation method suitable for the selected metallic material enables control of the thickness of DLC film formed on the film formation target surface with a strong adhesion.

Moreover, a metal object 36 with DLC film which is formed in the first embodiment (a metal object with diamond-like film) includes the DLC film 34 on the metallic film formation target 30. Accordingly, the metal object 36 with DLC film can be configured so that the DCL film 34 having a Vickers hardness of 900 to 1300, which is such a range that the DLC film 34 is industrially applicable enough, and having a frictional coefficient of about 0.2 to 0.4 is formed on a metal having a strength higher than that of a non-metal film formation target (for example, a substrate) which is resistant to high temperature. On the metal object 36 with DLC film, a layer which has a Vickers hardness slightly lower than the DLC film 34 and is easily separated is sometimes formed on the outermost surface. However, even if the layer is separated, the DLC film 34 is still left on the metal and can contribute to enough hardness.

As for the flow rate of the film formation gas RG, it is preferable that the film formation gas RG flows so as to come into contact with the film formation target surface 30f (a film formed surface) as slowly as possible. This is based on the consideration that the temperature of the film formation gas RG lowers if the film formation gas RG flows at an excessively high flow rate and based on the consideration of efficient use of the film formation gas RG. However, if the flow rate thereof is excessively low, carbon as a raw material of DLC film cannot be sufficiently supplied. The flow rate therefore should be set to a moderate value in consideration of the dimensions of the electric furnace 26, the dimensions of the substrate, and the like.

In the process of raising the temperature at the impurity removal/film formation step, the film formation target surface 30f is cleaned, and the reaction of depositing the DLC film occurs simultaneously. Accordingly, the longer the time period taken to raise the temperature, that is, the more slowly the temperature is raised, the more stable the formed DLC film 34. To raise the temperature from room temperature to 800°C, for example, it is preferable to take 2 to 8 hours.

After the temperature is raised to the predetermined temperature, the temperature is held so that the film formation gas RG reacts with metallic elements in the film formation target surface to further form the DLC film 34. Accordingly, the longer the time period for which the temperature is held constant, the thicker the formed DLC film 34 becomes. If the temperature is raised within a comparatively short time period, it is preferable that the temperature is held constant for a longer time period (temperature holding time). When the time period taken to raise the temperature from room temperature to 800°C is not less than 2 hours and less than 4 hours, it is preferable that the time period for which the temperature is held at 800°C is set to 4 hours or more.

Argon gas is used in order to control the concentration of methane gas in the film formation gas to adjust the film formation speed and the like, and is also used to prevent the pressure in the flow channel 14 from becoming negative. Accordingly, the film formation speed is set in consideration of the shape of the film formation target surface (film formed surface), the time period taken to raise the temperature, the target temperature, the temperature holding time, and the like, and the concentration of methane gas is determined to a predetermined concentration so that the determined film formation speed be achieved. The film formation gas can be 100% methane gas. This can shorten the time period to raise the temperature and the time period for which the temperature is held constant (800°C) for film formation after the temperature is raised. The gas mixed in the film formation gas can be inert or nitrogen gas instead of argon gas.

In the description of the first embodiment, the DLC film 34 is formed on the film formation target surface 30f on one side of the DLC film 34. However, since DLC film can be formed on the film formation target surface in contact with the film formation gas, the DLC film 34 can be formed on the entire surface of the film formation target 30 which is in contact with the film formation gas (see the DLC film 34 indicated by two-dot chain lines and solid lines in Fig. 1(a) and Fig. 1(b)).

### [Second Embodiment]

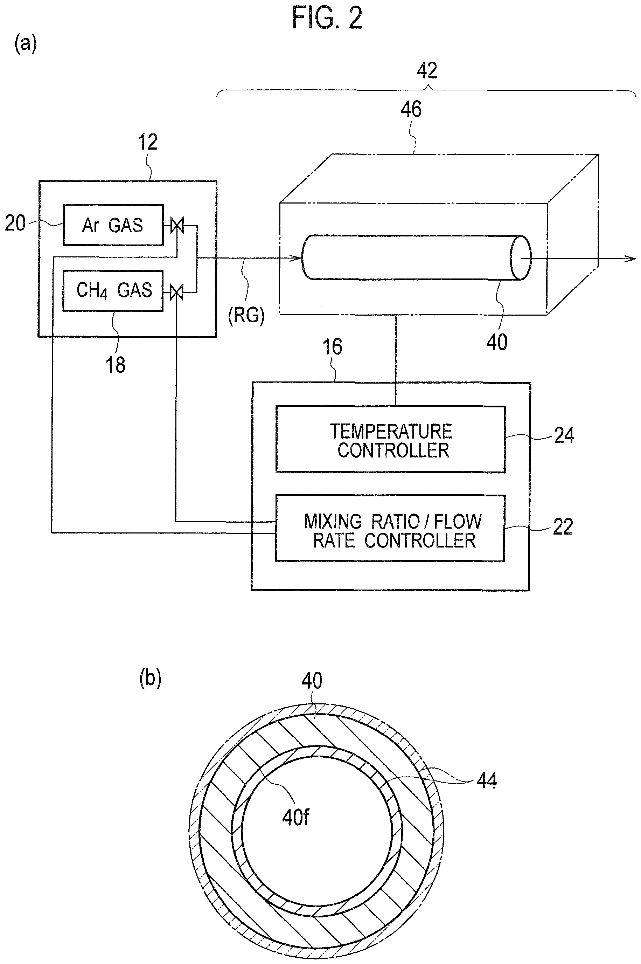

Next, a description is given of a second embodiment. Fig. 2(a) is an explanatory view explaining formation of DLC film on the inner surface of a metallic tube in the second embodiment, and Fig. 2(b) is a cross-sectional view illustrating formation of DLC film.

In the second embodiment, the film formation target is a metallic tube 40, which constitutes a part of a flow channel 42. In other words, the flow channel 42 is configured to cause the film formation gas RG to flow through the metallic tube 40.

In the second embodiment, in a similar manner to the first embodiment, the film formation gas RG is caused to flow while the metallic tube 40 is heated with an electric furnace 46. In this process, it is preferable that heating is started after gas (air) within the metallic tube 40 is replaced with the film formation gas RG. This can prevent methane gas from reacting with oxygen contained in the air within the metallic tube in the process of heating. The metallic tube 40 and a gas pipe configured to supply the film formation gas RG can be heated with a heater or the like instead of the electric furnace 46.

Methane gas is brought into contact with an inner surface 40f of the metallic tube 40 under the process of raising the temperature of the metallic tube 40 from room temperature to the predetermined temperature so that impurities in the inner surface 40f react with the film formation gas RG into gas form. The impurities are thereby removed from the inner surface 40f, and metallic elements of the inner surface 40f exposed by the removal of impurities react with the film formation gas RG, thus forming a DLC film 44 on the inner surface 40f.

As for the flow rate of the film formation gas RG, it is preferable that the film formation gas RG is caused to flow so as to come into contact with the metallic inner surface of the metallic tube as slowly as possible. This is based on the consideration that the temperatures of the metallic tube 40 and film formation gas RG lower if the film formation gas RG flows at an excessively high flow rate and based on the consideration of efficient use of the film formation gas RG. However, if the film formation gas flows at an excessively low flow rate, carbon as a raw material of the DLC film cannot be sufficiently supplied. The flow rate should be therefore set to a proper value in consideration of the dimensions of the electric furnace 46, the inner diameter of the metallic tube 40, and the like. As an example, if a gas mixture of methane gas and argon gas (the mixture ratio thereof is 1/9) is caused to flow into a metallic tube having a diameter of 40 mm, the flow rate of 60 ml/min can provide an adequate supply of carbon.

As for the concentration of methane gas in the film formation gas, in a similar manner to the first embodiment, the film formation speed is determined in consideration of the shape of the inner surface 40f (film formed surface) of the metallic tube 40, the time period taken to raise the temperature, the target temperature, the temperature holding time, and the like, and the concentration of methane gas is set to a predetermined concentration so that the determined film formation speed is achieved.

According to the second embodiment, it is possible to form the DLC film 44 on the inner surface 40f of the metallic tube 40, which is commercially-available, by the easy method at low cost. Moreover, it is possible to provide the metallic tube 40 with DLC film in which the DLC film 44 having a high hardness is formed on the inner surface 40f of the metallic tube 40 having a higher strength than that of non-metal substrates resistant to high temperature.

As described in the first embodiment, the DLC film 44 is formed using a pyrolytic reaction of the film formation gas on the inner surface 40f of the metallic tube 40. Accordingly, the DLC film 44 can be well formed even when the metallic tube 40 varies in inner diameter or includes fine irregularities in the inner surface 40f.

In the second embodiment, the film formation target is the metallic tube 40. However, the DLC film 44 can be formed on the inner surfaces of even general metallic tubes in a similar manner.

The DLC film 44 can be simultaneously formed on the entire surface of the metallic tube 40, including the inner and outer surfaces (see the DLC film 44 indicated by two-dot chain lines and solid lines in Fig. 2(a) and Fig. 2(b)) by using the electric furnace 46 similarly to the first embodiment and placing the metallic tube 40 in the electric furnace 46. It is therefore possible to simultaneously form the same DLC film on the inside and outside of the metallic tube 40, which is impossible by conventional plasma CVD.

### <Experimental Example 1>

The inventor examined formation of DLC films on six types of generally used steels by three types of treatment. The film formation target 30 was basically a plate of 1 cm by 1 cm in Experimental Example 1 as well as in Experimental Examples 2 to 5.

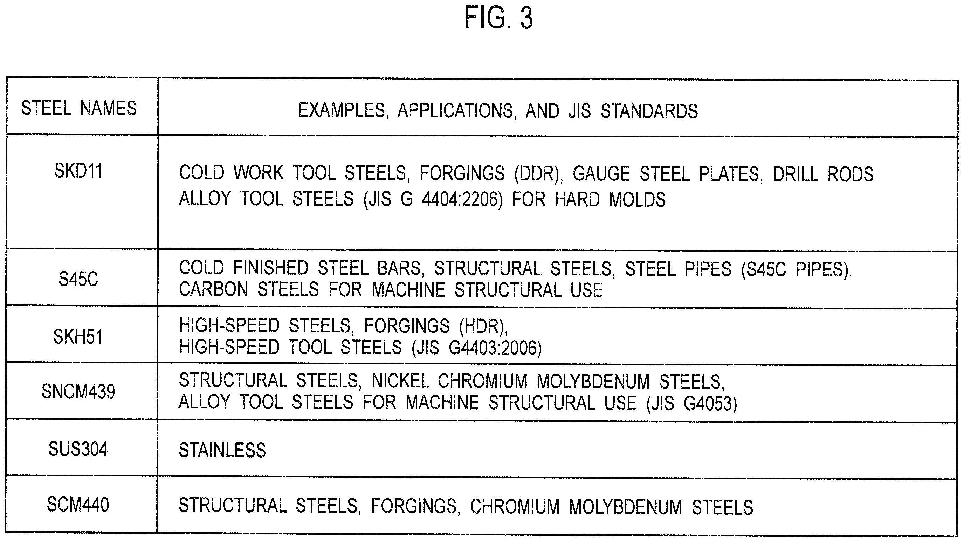

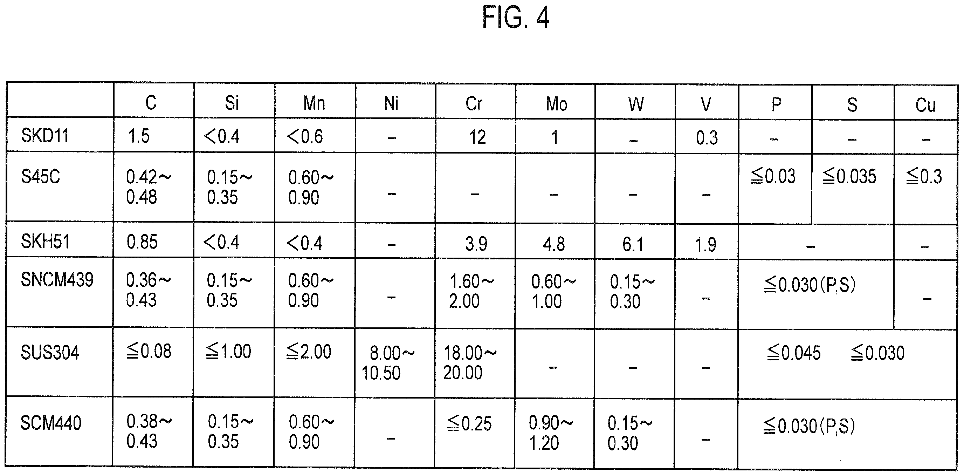

Fig. 3 is an explanatory diagram showing names of steels used in Example 1 and usage examples and applications thereof. Fig. 4 is an explanatory diagram showing small amounts of elements contained in each steel and the proportions thereof. The unit of values indicating the proportions is percent (%) . Each of the steels other than SUS304 is almost composed of iron (Fe). Each steel is known as having specific characteristics due to the small amounts of contained elements shown in Fig. 4. SUS304 contains 30% of Ni and Cr in total and accordingly contains a low proportion of iron. It is therefore necessary to be careful with the difference between SUS304 and the other steels.

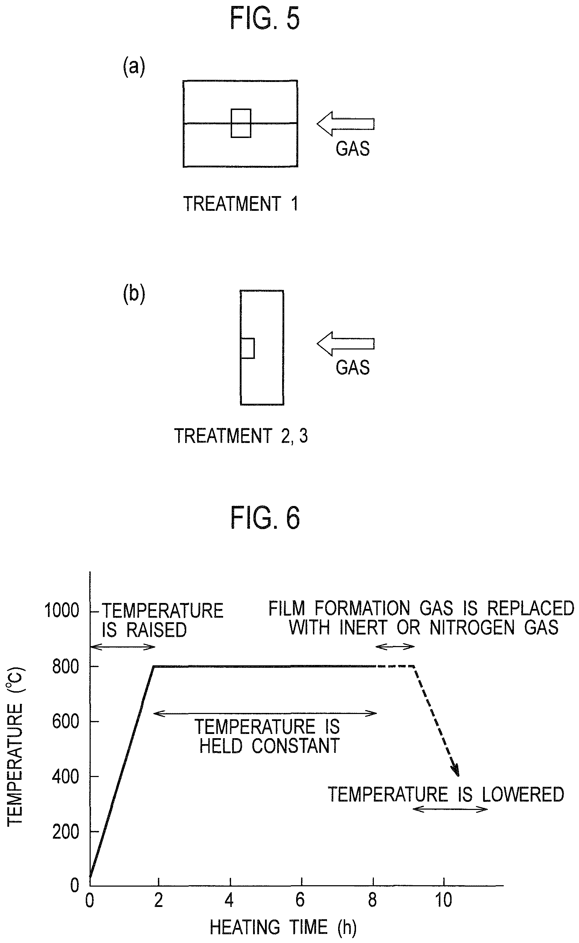

Fig. 5(a) and Fig. 5(b) show an explanatory view explaining the ways of placement of the film formation target in Experimental Example 1. Herein, Fig. 5 (a) is an example in which two plates 30 as the film formation targets are horizontally placed in a two-tiered manner with the film formation target surfaces 30f located at the top and bottom. The film formation target surfaces 30f are extended in parallel to the flow of the film formation gas RG. Hereinafter, such placement is referred to as just horizontal placement. Fig. 5 (b) is an example in which the plate 30 is vertically placed so that the film formation gas RG hits the film formation target surface 30f. Hereinafter, such placement is also referred to as just vertical placement.

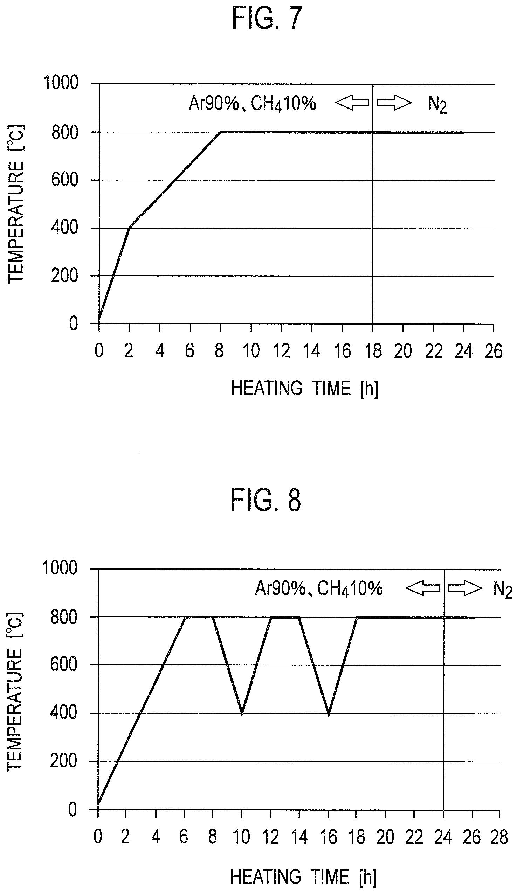

In Experiment Example 1, the temperature process of film formation was varied as the parameter. The experiments were performed with three temperature processes including first to third temperature processes. Figs. 6 to 8 are graphs showing changes in temperature in the first to third temperature processes.

In the first temperature process, the temperature is raised from room temperature to 800°C for 2 hours (2 h) and is held at 800°C for 6 hours (film formation for 6 hours).

In the second temperature process, the temperature is raised from room temperature to 400°C for 2 hours (2 h); then raised from 400°C to 800°C for 6 hours; and then held at 800°C for 8 hours (film formation for 8 hours).

In the third temperature process, the temperature is raised from room temperature to 800°C for 6 hours (6 h); then performs twice the temperature cycle of 800°C → 400°C → 800°C; and then held at 800°C for 8 hours (film formation for 8 hours).

In Experimental Example 1, the three types of treatment patterns including Treatments 1 to 3 below were properly performed for the aforementioned six types of steels.

### [Treatment 1]

Plate placement: Horizontal placement
Under the flow of film formation gas: CH₄ gas (60 ml/min) + Ar gas (60 ml/min)

Temperature process: First temperature process
Cooling of Substrate after film formation: the substrate is cooled to room temperature after the gas is replaced with Ar gas.

### [Treatment 2]

Plate placement: Vertical placement
Under the flow of film formation gas: CH₄ gas (10%) + Ar gas (90%) at 100 ml/min

Temperature process: Second temperature process
Cooling of Substrate after film formation: the substrate is cooled to room temperature after the gas is replaced with N₂ gas.

### [Treatment 3]

Plate placement: Vertical placement
Under the flow of film formation gas: CH₄ gas (10%) + Ar gas (90%) at 100 ml/min

Temperature process: Third temperature process
Cooling of Substrate after film formation: the substrate is cooled to room temperature after the gas is replaced with N₂ gas.

The common conditions of Treatments 1 to 3 described above are 1) to 3) below.

1) It is confirmed that there is no gas leakage from the gas flow system.
2) The pressure of the film formation gas is set equal to the atmospheric pressure.
3) In order to prevent oxidation by the air in the flow channel 14, the aforementioned gas mixture is caused to flow enough before heating (at least for 1 hour) for replacement of the air in the flow channel 14 with the film formation gas.

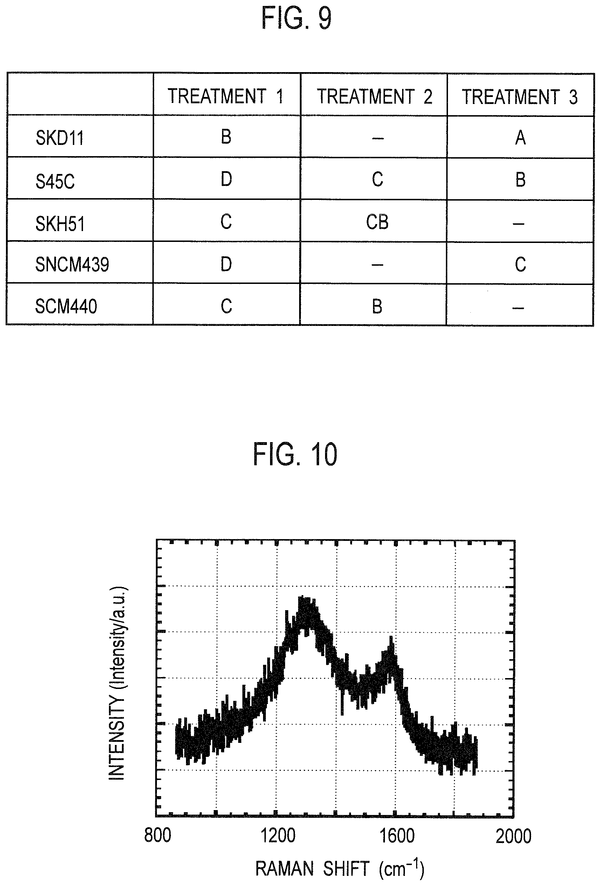

Fig. 9 shows the evaluation results. Characters "A", "B", "C", and "D" respectively indicate that the DLC film is very well formed, well formed, fairly well formed, and poorly formed. "-" indicates that no treatment was performed.

As described later, the thin film formed in Experiment Example 1 is determined to be a DLC film by Raman spectroscopy and is therefore referred to as DLC film hereinafter. Herein, on the samples evaluated as D, small amounts of DLC films are formed. Accordingly, it is possible to form DLC films having a predetermined thickness by increasing the time period for film formation. Moreover, Fig. 9 does not show evaluation of SUS304, but it is possible to form a good DLC film with a predetermined thickness even on a substrate of SUS304 by increasing the time period for film formation.

### (Examinations)

In Experimental Example 1, if methane gas as the reaction gas comes into contact more efficiently with the front and rear surfaces of a metallic sample, the contact time is considered to be increased. However, although the reaction time was as long as 6 to 8 hours after the temperature reaches 800°C in Treatments 1 to 3, just small amounts of DLC films were deposited on the samples of Treatment 1 while DLC films were comparatively well deposited on some types of steels (plates) in Treatments 2 and 3.

Based on the aforementioned fact, the following 1) to 3) are considered in terms of the process of heating from room temperature to 800 °C. 1) Importance of such a physical position of a sample that can maximize reaction gas that comes into contact with the surface of the sample, 2) the possibility that cleaning of the surface of the metallic sample can promote methane decomposition reaction, and 3) the possibility that reaction in which carbon generated by methane decomposition on the surface becomes DLC can proceed.

The results of S45C reveal that DLC film is well formed by the process of repeating the cycle of 800°C → 400°C → 800°C. This fact is considered to show that the generation of carbon and the reaction in which the generated carbon becomes DLC proceed between 400 and 800°C.

Herein, in order to examine the importance of 1), metallic samples (plates) made of four types of steels including SKD11, S45C, SKH51, and SCM440 were each placed vertically as performed in Treatments 2 and 3, and then the first temperature process (the temperature treatment process used in Treatment 1) was performed to form DLC films. As a result, compared with the case where the plates were horizontally placed in Treatment 1, as shown in Fig. 9, it is observed that the DLC film was well formed on each plate. From these results, the following findings can be obtained.
1) The time period of contact with the reaction gas is important, and the position of each metallic sample is important accordingly.
2) In order to form enough DLC film on an object having a complicated shape, it is important to cause the reaction gas to flow as slowly as possible so that the reaction gas adequately spreads on the surface of the sample to cause the reaction to proceed.

### <Experimental Example 2>

In Experimental Example 2, a plate of SKD11 was vertically placed, and film formation was performed with the first temperature process. The film formed on the plate was analyzed by Raman spectroscopy. The chart obtained by the Raman spectroscopy is shown in Fig. 10. The formed film is determined to be DLC film based on the fact that two broad signals are observed around 1300 and 1600 cm⁻¹, that is, signals called the D and G peaks, respectively. The other types of steels (plates) were subjected to film formation through the first to third temperature processes. The formed films were analyzed by Raman spectroscopy, thus obtaining similar charts.

### (Raman spectrum)

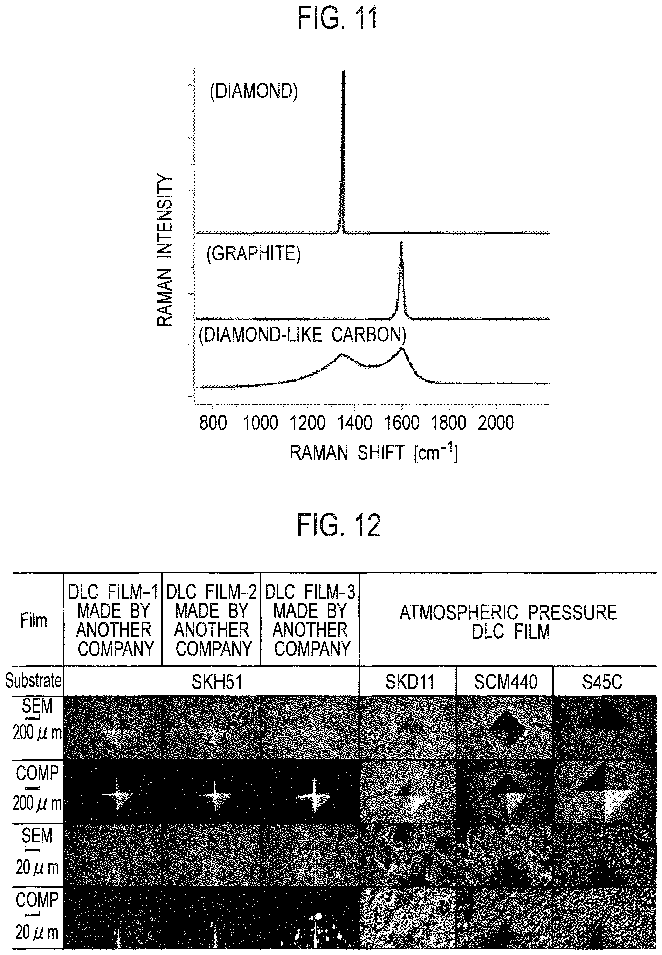

The difference in Raman spectra of carbon materials due to the different crystallinity thereof is known as a chart shown in Fig. 11 (Ref. Hidetoshi Saito, DLC handbook, NTS Inc. (2006)). As shown in Fig. 11, Raman scattering spectroscopy for graphite using a visible light laser usually used shows one sharp peak at 1584 cm⁻¹. This oscillation mode is called G-band after the first letter of graphite. Graphite has a high phonon density of states in a region around 1350 cm⁻¹, but is not Raman active. The spectrum of high-crystallinity graphite therefore does not show any peak. However, if defects are introduced, a Raman peak is observed. This peak is called D-band as a peak derived from defects. The D-band, which is derived from defects, is observed with high intensity in low-crystallinity graphite, amorphous, and nanoparticles. In the oscillation mode of diamond, which is of the same carbon crystal but has a different crystalline structure from graphite, one sharp peak appears at 1333 cm⁻¹ and is used to evaluate the crystallinity of fine crystals, thin films, and the like.

In carbon materials not having a complete crystal structure, unlike diamond or graphite, two Raman peaks are observed. The higher the crystallinity, the sharper the peaks, and the narrower the half-value width. DLC does not have a complete crystal structure like diamond and graphite and can be distinguished by Raman spectra thereof. Recently, Raman spectra therefore play an important role in evaluation of DLC used for surface protection of hard discs and cutting tools.

As for the Raman spectra, the following 1) to 3) are reported in some journals.

### 1) <Finding about Raman signals of single crystal graphite and crystal size>

(Ref. F. Tuinstra, J. L. Koenig, J. Chem. Phys., 53, 1970, 1126-1130)

In the Raman spectrum of single crystal graphite, a sharp peak is observed at 1575 cm⁻¹, and as for graphite with a smaller crystal size or diameter, a peak is observed at 1355 cm⁻¹ The smaller the crystal diameter, the higher the intensity ratio of the peaks at 1355 cm⁻¹ and 1575 cm⁻¹.

### 2) <Verification of effects of diamond, sp²-bonded carbon, and hydrogen by varying excitation wavelength>

(Ref. J. Wagner, M. Ramsteiner, Ch. Wild, P. Koidl, Phys. Rev., B40, 1989, 1817-1824)

It is examined that the Raman spectrum of diamond shows a sharp Raman signal at 1332 cm⁻¹. A broad Raman signal of graphite having a broken structure is observed at 1300 to 1350 cm⁻¹, and Raman scattering from sp²-bonded carbon is analyzed to be at 1580 to 1600 cm⁻¹. These lead to the findings concerning the D and G peaks. With a low excitation energy (a long excitation wavelength), the intensity of the G peak is increased. The G peak of amorphous carbon containing hydrogen is shifted to the lower wavenumber side.

### 3) The Raman scattering efficiency of graphite is 50 times higher than that of diamond

The spectrum of graphite shows signals stronger than those of the same amount of diamond.

(Ref. Wada, P. J. Gaczi, S. A. Solin, J. Non.-Cryst. Solids 35&36, 543, 1980)

### (Examinations)

In the spectrum of DLC film manufactured by a conventional plasma method, the G peak is strong, and the D peak is observed as a shoulder. The reason why many literatures are discussing the ratio of D and G peaks in relation to the strength of the DLC film is undeniably because of the rationalization for the strength of the DLC film obtained by the plasma process.

On the other hand, in the spectrum of DLC manufactured by hydrocarbon pyrolysis, the D peak is prominently observed. The aforementioned literatures reveal that normal Raman scattering experiments, which use an Ar laser for excitation, corresponds to the low excitation laser in the literature by Wagner et al. and the G peak therefore should be observed stronger. Most of information included in the D peak is due to graphite of small size. The information which can be obtained by Raman spectroscopy is therefore that DLC is composed of graphite having small crystal diameter, which can be considered as a cause of low frictional force described later.

The strength of DLC film has been discussed based on the ratio of G and D peaks. However, the Raman signal includes superposed signals by various species, and actually, DLC film cannot be analyzed in detail yet. On the other hand, comparison of hardness (mainly derived from sp³-bonded carbon), frictional coefficient (mainly derived from sp²-bonded carbon), and the like which are analyzed by Raman spectra and another method based on the above experimental results can develop the analysis of DLC film.

### <Experimental Example 3>

In Experimental Example 3, the plates 36 with DLC films (the DLC films were formed on the plates under the flow of film formation gas at the atmospheric pressure. See Fig. 1(b). Hereinafter, the DLC film formed under the flow of film formation gas at the atmospheric pressure is also referred to as an atmospheric pressure DLC film) which include DLC films formed on various plates in Experimental Example 2 were measured in terms of Vickers hardness of the DLC films with a hardness standard tool "Hardnester" (made by Yamamoto Tool Scientific Laboratory). As a result, the Vickers hardnesses of the atmospheric pressure DLC films were about 1000.

Indentations were measured, which were formed by pressing a diamond indenter against the surface of each sample for 10 seconds with test loads of 49, 98, 196, 294, and 490 N, calculating micro-Vickers hardness. As a result, the Vickers hardnesses of the atmospheric pressure DLC films were numerically from 900 to 1300, which shows that the DLC films had enough hardness.

Next, the atmospheric pressure DLC films were evaluated based on the shape of each indention by the micro-Vickers test. Plates of SKD11, SCM440, and S45C with a size of 1 cm x 1 cm x 0.5 cm as metallic objects on which films are to be formed were placed vertically and were subj ected to film formation with a temperature profile of the first temperature process, forming DLC films. The DLC films were subjected to a micro-Vickers test to form indentions for evaluation. Fig. 12 is a diagram of photographs showing shapes of the indentations by the micro-Vickers test.

Fig. 12 also shows the results for three types of DLC films made by another company (DLC-1 to DLC-3 made by another company with a plasma method) for comparison. Herein, the SEM and COMP images are observed with sizes of 200 µm and 20 µm.

As can be seen from Fig. 12, in comparison between the DLC films made by another company and the atmospheric pressure DLC films manufactured by the method of the present invention, each indentation by a large load of 490 N includes very small crack and separation around the indention, but there are no traces for large separation. This means that the DLC films manufactured under the flow of film formation gas at the atmospheric pressure (the atmospheric pressure DLC films) are comparable to DLC films made by a plasma process in terms of separation resistance and strength.

### <Experimental Example 4>

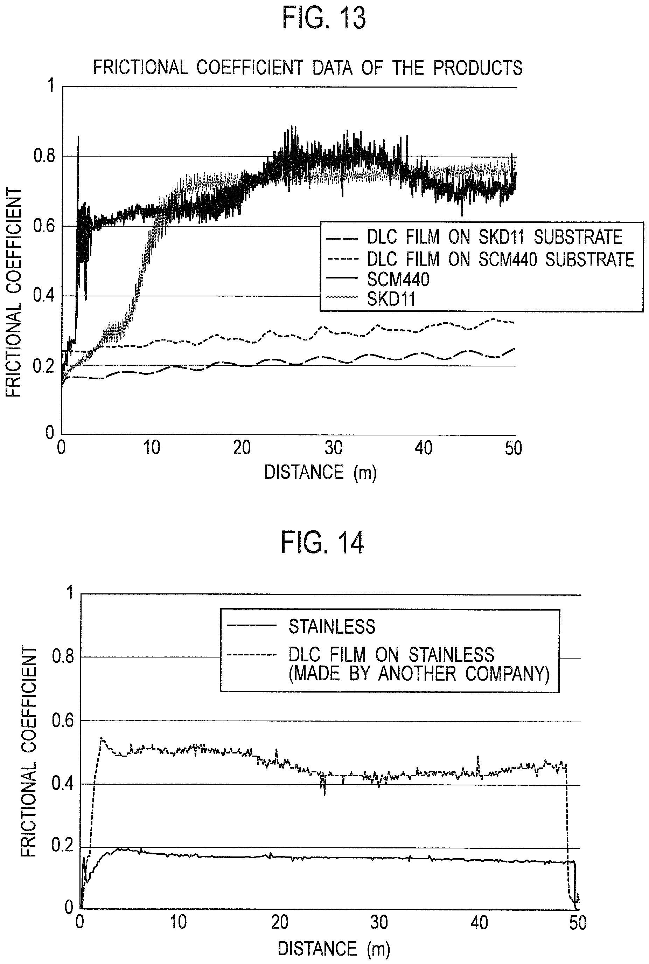

In Experimental Example 4, the frictional coefficients measured with a ball-on-disk tribometer for DLC films which were formed on plates of SKD11 and SCM440 under the flow of film formation gas at the atmospheric pressure. The measurement results thereof are shown in Fig. 13. For comparison, the frictional coefficients of DLC films were measured in a similar manner for samples which were made by another company and include DLC films formed on stainless plates (made by Nanotech corporation, DLC film thickness: 3 µm). The measurement results thereof are shown in Fig. 14. In Figs. 13 and 14, the vertical axis indicates the frictional coefficient, and the horizontal axis indicates the distance (travel distance) by which a metallic ball is rotated on the sample surface to abrade the same as the tribometer. Figs. 13 and 14 show the results from 50 m travel of the metallic ball.

In Experimental Example 4, the frictional coefficients were also measured for the surfaces of the SKD11 and SCM440 plates as the base material. The results thereof are shown in Fig. 13 together. The frictional coefficients of the stainless plate surfaces were also measured, and the results thereof are shown in Fig. 14 together.

As can be seen from Fig. 13, the frictional coefficients of the SKD11 and SMC440 plates increase as the travel distance increases and become large values of 0.6 to 0.8. On the other hand, the frictional coefficient of the atmospheric pressure DLC film on the SKD11 is in a range of 0.20 plus or minus 0.05 at a travel distance of not longer than 50 m. The frictional coefficient of the atmospheric pressure DLC film on the SCM440 plate is in a range of 0.30 plus or minus 0.05 at a travel distance of not longer than 50 m, which are smaller than those of the base materials (plates).

The frictional coefficient value of the DLC film made by another company (made by Nanotech corporation, DLC thickness: 3 µm) measured 0.18 with the ball-on-disc tribometer, which was a good low value. This reveals that the frictional coefficient of the atmospheric pressure DLC film is a little larger than that of the DLC film formed by the plasma process but is adequately a practical level.

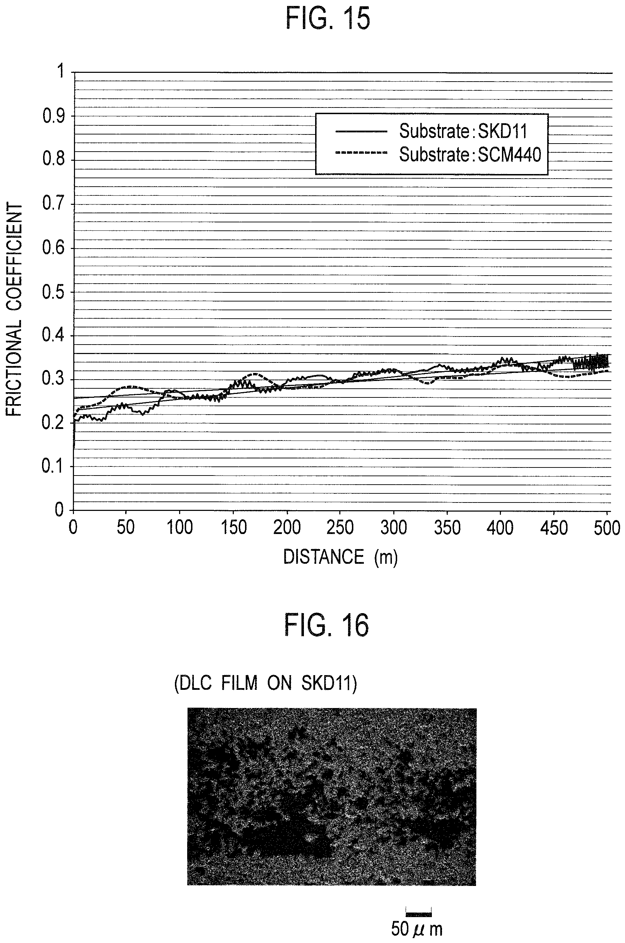

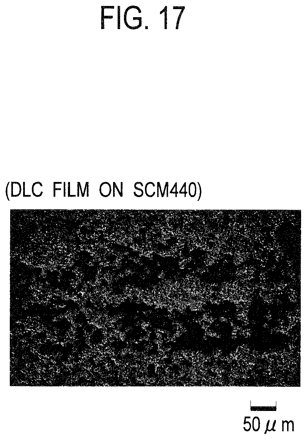

In Experimental Example 4, the travel distance was extended to 500 m. The frictional coefficients of the atmospheric pressure DLC films on the SKD11 and SCM440 were measured, and the traces on the DLC films by the metallic ball were observed with the SEM. The measurement results of the frictional coefficients are shown in Fig. 15, and the observed images are shown in Figs. 16 and 17. Fig. 16 shows an observed image of the DLC film formed on the SKD11 plate, and Fig. 17 is an observed image of the DLC film formed on the SCM440 plate.

The frictional coefficients were small values of about 0.2 just after the travel distance exceeded 50 m and increased to only about 0.36 even at the end of the travel of nearly 500 m, which was a value low enough. The observation of the SEM images of Figs. 16 and 17 show that carbide is left streaky. It is estimated that the left carbide contributes to the low friction.

### <Experimental Example 5>

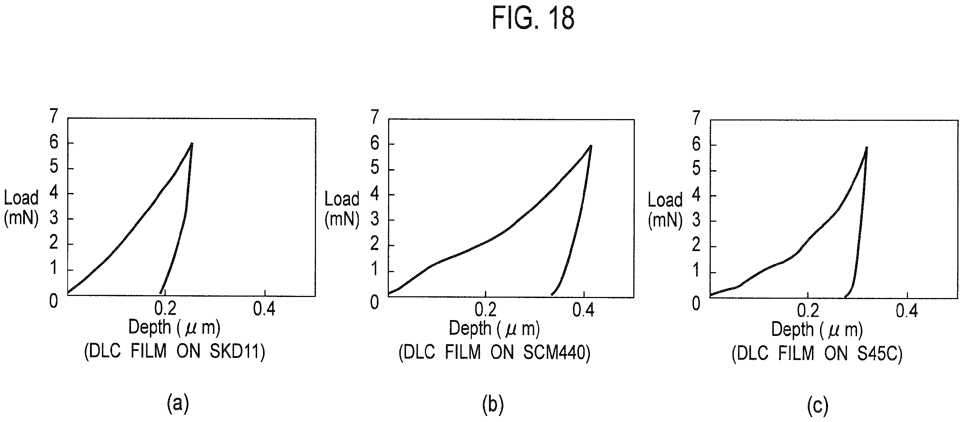

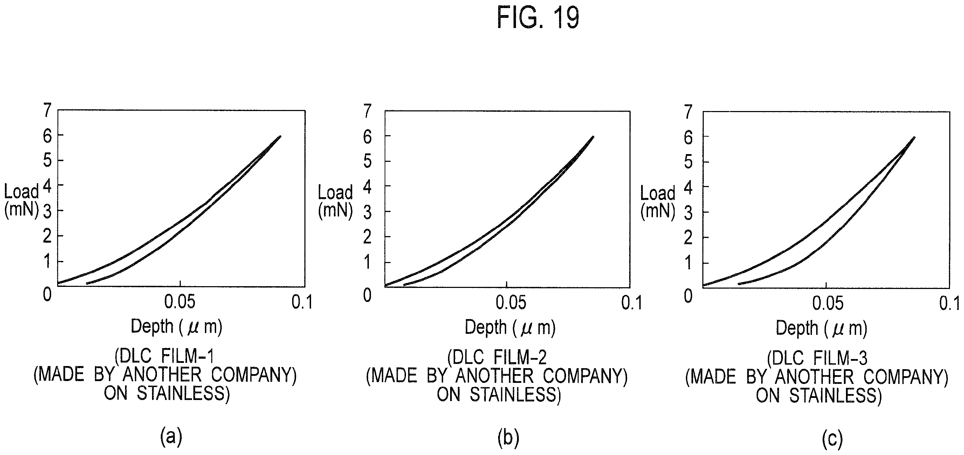

In Experimental Example 5, the hardnesses of the DLC films were measured through a nanoindentation test for atmospheric pressure DLC films formed under the flow of the film formation gas at the atmospheric pressure on the plates of SKD11, SCM440, and S45C placed vertically. The measurement results thereof are shown in Fig. 18(a) to Fig. 18(c). For comparison, the nanoindentation test was performed to measure the DLC film hardness in a similar manner for DLC films formed on stainless plates made by another company (made by Nanotech corporation, DLC thickness : 3 µm). The measurement results thereof are shown in Fig. 19(a) to Fig 19(c). In Figs. 18(a) to Figs. 19(c), the vertical and horizontal axes indicate the load (mN) and the depth of press (µm), respectively. As for the DLC films made by another company, three samples were prepared, and the nanoindentation test was performed once for each sample, totally three times. As for the samples produced by the inventor, the nanoindentation test was performed once for each plate.

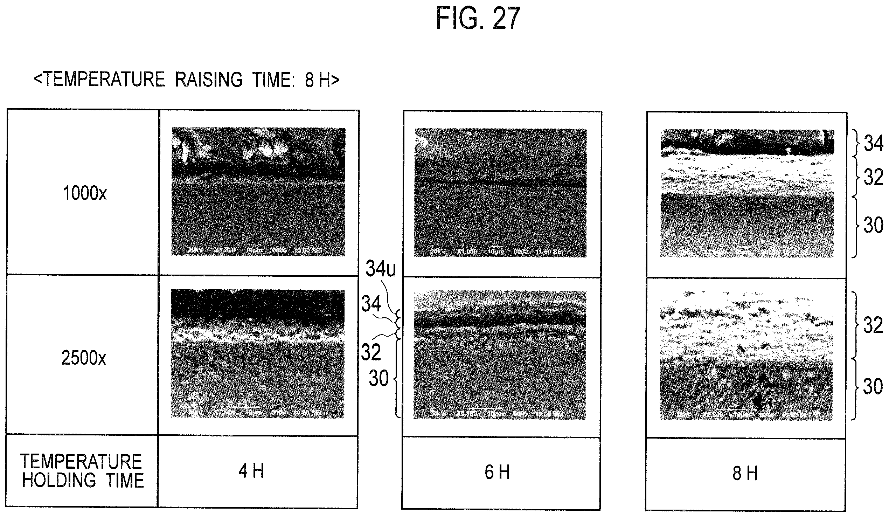

As can be seen from Fig. 19(a) to Fig. 19(c), in the DLC film made by another company, the relationship between the force applied to the indenter pressed into the sample by about 0.1 µm from the top surface and deformation of the sample was substantially the same as the relationship between the force and deformation when the force was reduced. This shows the existence of a hard layer in the outermost layer. On the other hand, as shown in Fig. 18(a) to Fig. 18(c), in the nanoindentation test for the atmospheric pressure DLC films deposited on the plates of SKD11, SCM440, and S45C, the force applied as a load when the measurement indenter was displaced by 0.1 µm in the depth direction changed while the indenter was being pressed. On the other hand, even when the applied force was reduced, the displacement hardly changed. This means that each atmospheric pressure DLC film includes on the outermost side, an outermost layer which is comparatively soft and undergoes irreversible deformation against force (for example, an outermost layer 34u shown in Fig. 27).

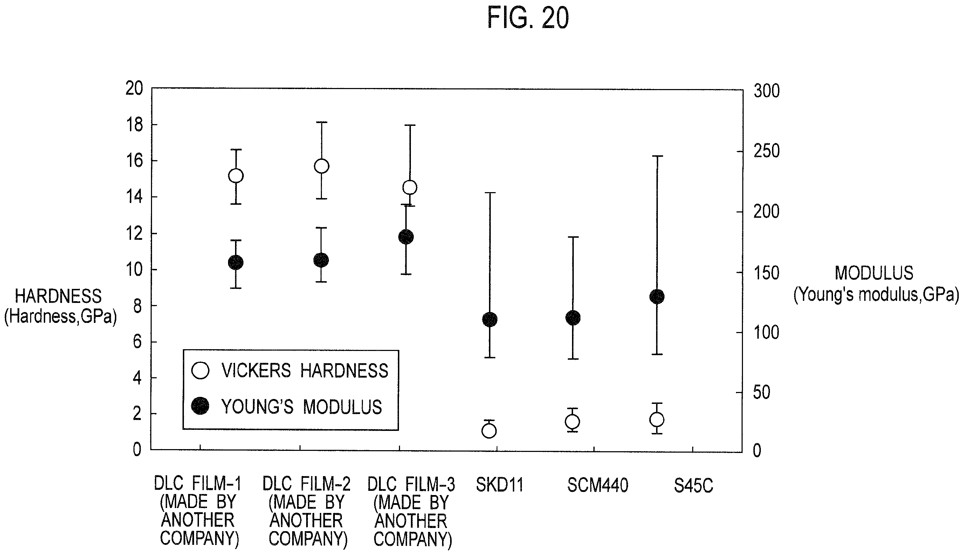

Furthermore, in Experimental Example 5, measurement of the Vickers hardness and Young's modulus of the region between the outermost surface and a depth of 0.1 µm in each DLC film was performed for the aforementioned six samples (the three samples produced by the inventor and three samples made by another company). The measurement results thereof are shown in Fig. 20.

As can be seen from Fig. 20, the Vickers hardness of the outermost layers 34u of the atmospheric pressure DLC films (see Fig. 27) was lower than that of the DLC films made by another company, but the Young's modulus of the outermost layers 34u is substantially the same as that of the DLC films made by another company. The numerical values of the Young's modulus of 100 to 200 GPa were smaller than the Young's modulus of diamond (about 1000), and it was found to be a material which strains to a certain degree under stress. The aforementioned values of the Young's modulus are equivalent to the Young's modulus of steel and higher than the Young's modulus of the DCL films formed by a normal plasma process, which are 70 to 80 GPa. The Young's modulus (E) is defined as a value obtained by dividing stress (σ) by strain (ε).

### <Experimental Example 6>

In Experimental Example 6, in order to reveal the property of the atmospheric pressure DLC film being resistant to separation from metal, a scanning-type electronic microscope (SEM) and an energy dispersive X-ray analyzer (EDX) provided for the same were used to perform an elemental analysis for the interface between DLC film and metal.

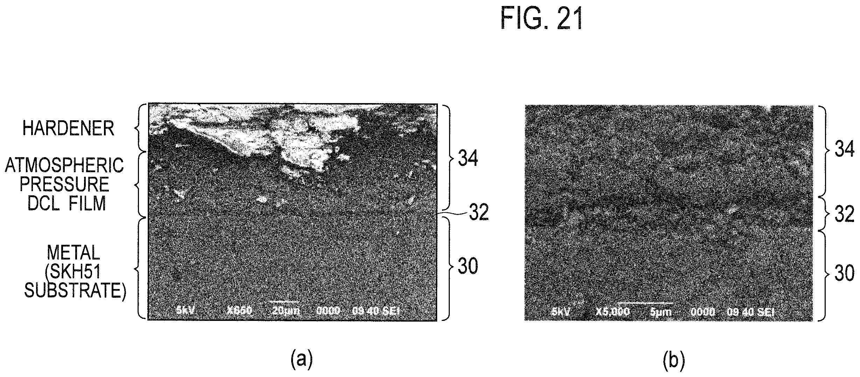

In Experimental Example 6, to obtain cross-sectional SEM images, the sample surfaces are coated with a resin hardener, and the samples were cut to form cross-sections for observation. The metallic film formation target on which the atmospheric pressure DLC film was to be formed was a plate of SKH51 placed vertically, and film formation was performed through the first temperature process. The measurement results thereof are shown in Fig. 21(a) and Fig. 21(b). The intermediate film 32 (an interface film) with a thickness of about 3 µm was observed between the produced DLC film 34 with a thickness of about 40 µm and the metallic plate (the plate of SKH51) 30.

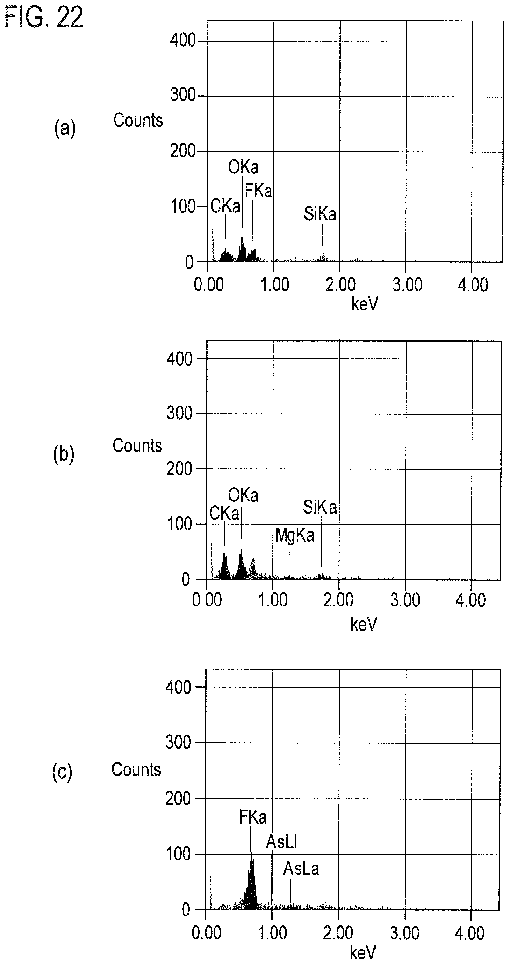

Fig. 22(a) to Fig. 22(c) shows the results of the elemental analysis performed with the EDX for each portion corresponding to the atmospheric pressure DLC film 34, intermediate film 32, and metallic plate (the plate of SKH51) 30. It is found that the DLC film 34 is certainly composed of carbon (C) and the intermediate film 32 is composed of substantially 100% carbon (C) .

### <Experimental Example 7>

The inventor carried out the following experiment to find out the cause of the atmospheric pressure DLC film being resistant to separation from metal.

In the first temperature process, the time period taken to raise the temperature from room temperature to 800°C was set to three patterns: 1) 2 hours, 2) 8 hours, and 3) 14 hours. Moreover, the time period for which the temperature was held constant (film formation time) after reaching 800°C was set to three patterns of 4) 4 hours, 5) 6 hours, and 6) 8 hours.

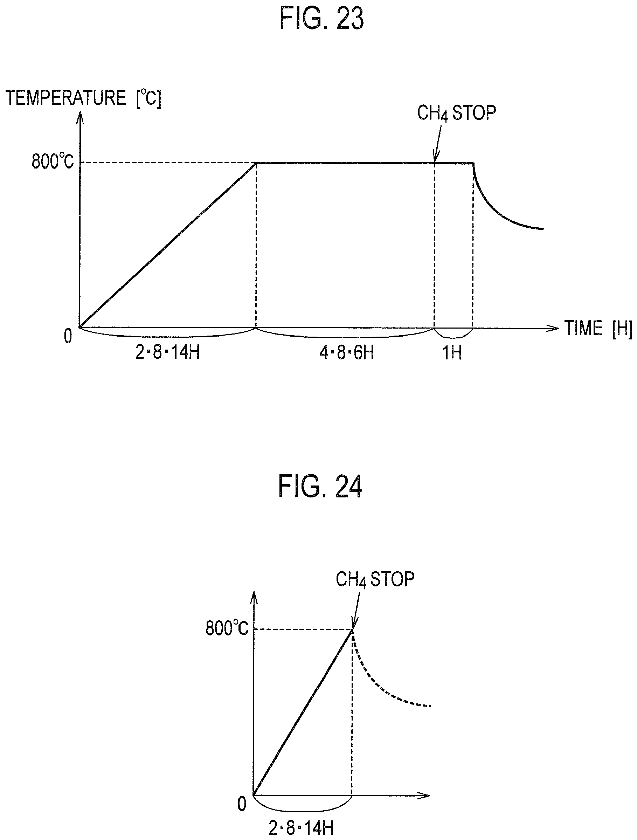

The ratio of components of the film formation gas (the ratio of methane gas to argon gas is set to 1/9) was set to a same value in each of the tests, and the sample was naturally cooled in the argon gas atmosphere after film formation in the same manner. Accordingly, in the above patterns 1) to 6), therefore, the aforementioned film formation gas was always flowing. Fig. 23 shows an explanatory diagram of the test conditions.

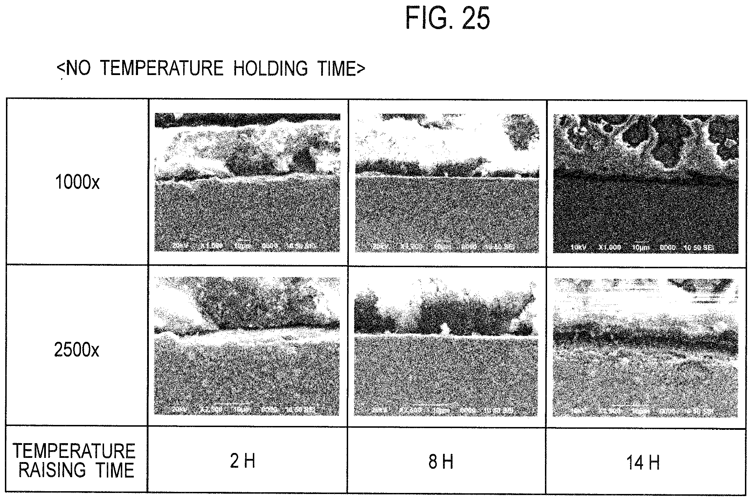

For comparison, the time period taken to raise the temperature from room temperature to 800°C was set to three patterns: 1) 2 hours, 2) 8 hours, and 3) 14 hours. The samples were naturally cooled with no holding time at 800°C (see Fig. 24 for the temperature process). The sample surfaces were coated with a resin hardener, and the samples were cut to form cross-sections for observation with the SEM. The observation results are shown in Fig. 25. As can be seen from Fig. 25, the outermost layer is not observed significantly in each sample, and the intermediate layer is also very thin. In the sample which was subjected to the process of raising the temperature for 2 hours (temperature raising time: 2 hours), even the intermediate layer is not observed.

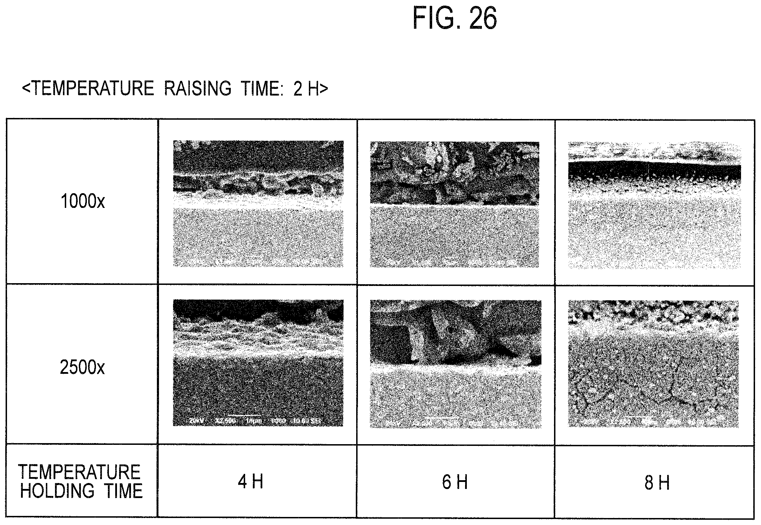

Next, DLC films were formed by raising the temperature to 800°C for 2 hours, holding the temperature at 800°C (film formation time) for 4) 4 hours, 5) 6 hours, and 6) 8 hours, and naturally cooling the same (see Fig. 23 for the temperature process) . The sample surfaces were coated with a resin hardener, and the samples were cut to form cross-sections for observation with the SEM. The observation results are shown in Fig. 26.

In a similar manner, the DLC films were formed by raising the temperature to 800°C for 8 hours, holding the temperature at 800°C (film formation time) for 4) 4 hours, 5) 6 hours, and 6) 8 hours, and then naturally cooling the same (see Fig. 23 for the temperature process) . The sample surfaces were coated with a resin hardener, and the samples were cut to form cross-sections for observation with the SEM. The observation results are shown in Fig. 27.

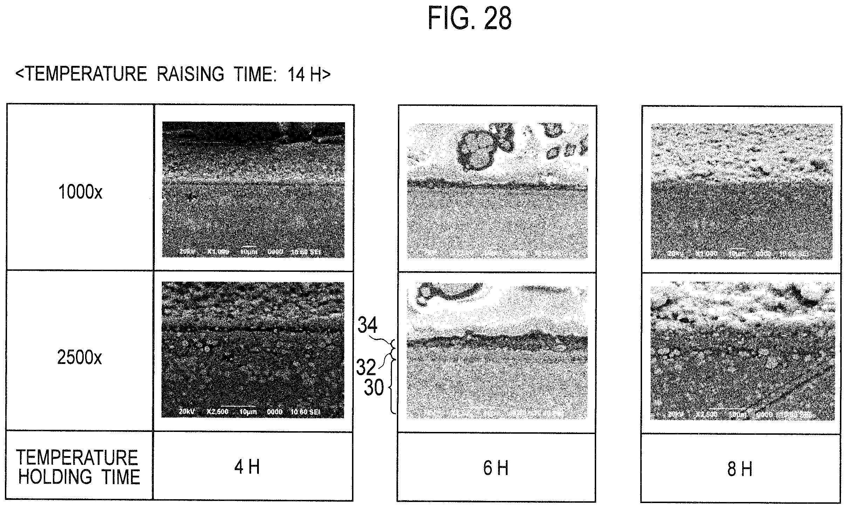

In a similar manner, the DLC films were formed by raising the temperature to 800°C for 14 hours, holding the temperature at 800°C (film formation time) for 4) 4 hours, 5) 6 hours, and 6) 8 hours, and naturally cooling the same (see Fig. 23 for the temperature process). The sample surfaces were coated with a resin hardener, and the samples were cut to form cross-sections for observation with the SEM. The observation results are shown in Fig. 28.

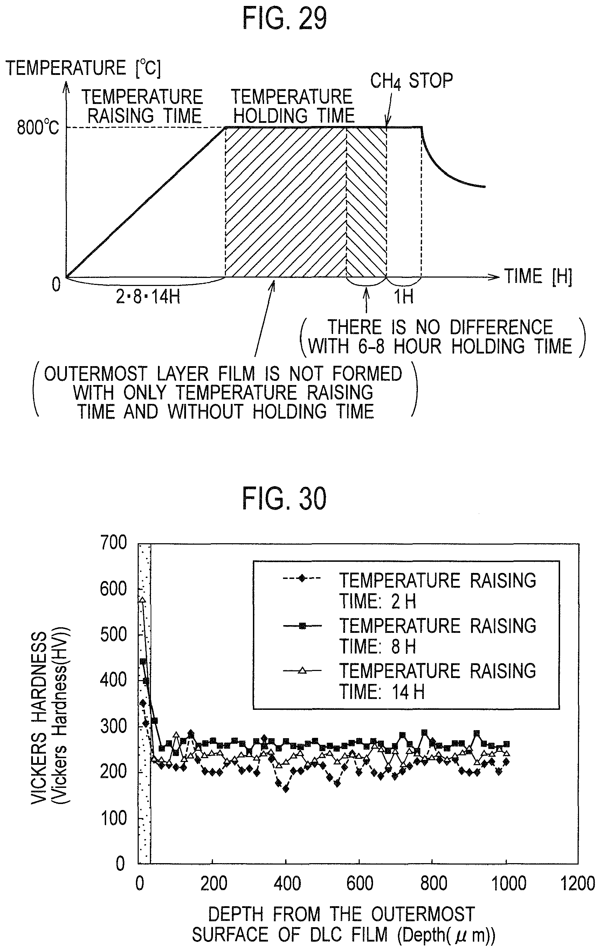

The inventor examined the influence of the temperature raising time and holding time on film formation of DLC films with reference to Figs. 25 to 28 to create Fig. 29 and then found the following things;
a) The aforementioned outermost layer was not observed when the temperature raising time was 2 hours. There was no great difference in the cross-sectional shape among the samples when the holding time was set to 4 hours or more.
b) The intermediate film 32 looking like cracks produced in the SKH51 as the base material exists under the DLC film. The longer the time period for which the sample was exposed to a high temperature environment, that is, the longer the holding time at 800°C, the thicker the intermediate film 32 tended to be (see Figs. 27 and 28).
c) Cracks appeared to be produced only in the intermediate film 32 formed with the temperature raising time set to 8 hours. No crack appeared to be included in the intermediate films 32 formed with the temperature increasing time and holding time respectively set to 2 and 4 hours. Accordingly, if crack is produced by the influence of temperature, it is thought that crack starts to be generated in a 6 to 8 hour time period for which the sample is held at 800°C. d) It is considered that film formation can be stabilized in a range of the holding time at 800°C from 0 to 6 hours.

The existence of the intermediate film 32 which had a thickness of 10 to 20 µm in the substrate of SKH51 as a base material and looked like including some cracks was confirmed under each of the atmospheric pressure DLC films which were formed with the time period for the temperature to reach 800°C varied to 2, 8, and 14 hours and the holding time at 800°C set to 8 hours. For the purpose of obtaining information of the intermediate film 32, especially concerning the hardness, the Vickers hardness between the outermost surface of each DLC film and the metallic substrate 30 was measured in the sample cross-section using a micro-hardness tester HMV-2000 (made by Shimazu Corporation). The measurement results thereof are shown in Fig. 30.

Although the HV values on the vertical axis include large errors because the sample pieces were cross-sections, the diagram shows that the surface layers of the DLC films had enough hardness. The Vickers hardness of the intermediate film 32 can be higher than that of the metallic base materials.

The inventor has drawn the following conclusion based on the aforementioned experiment results and examinations.
1) The intermediate film 32 with a thickness of 2 to 5 µm is generated between the DLC film 34 and the metallic plate 30 and enhances the physical strength between the DLC film 34 and metallic plate 30, contributing to the property of being resistant to separation.
2) The process of producing the intermediate film 32 is promoted as the time period taken to raise the temperature to 800°C increases or as the reaction time at 800°C increases.

### [Third Embodiment]

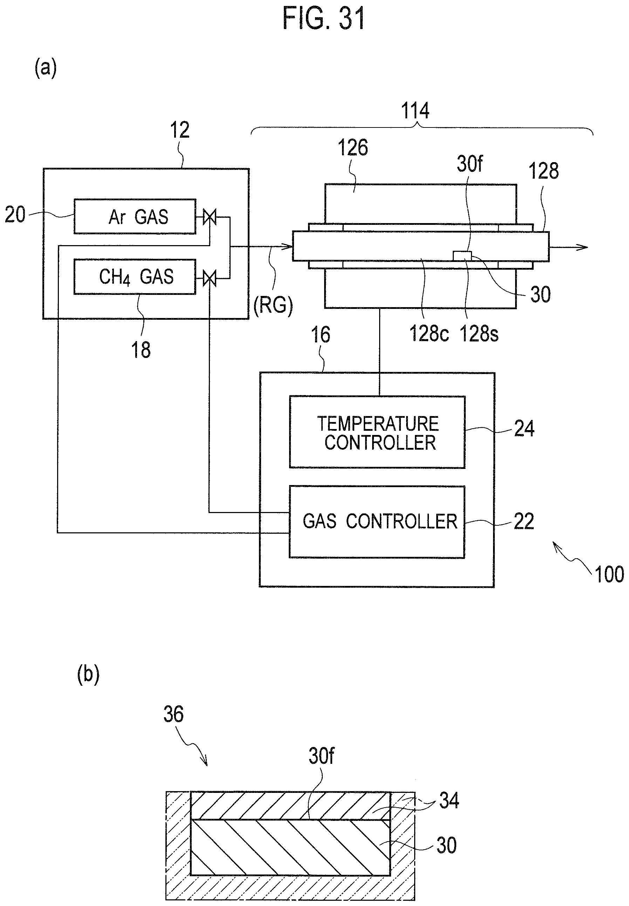

Next, a description is given of a third embodiment. Fig. 31(a) is a schematic view illustrating the concept of a film formation apparatus used in a third embodiment, and Fig. 31 (b) is a cross-sectional view showing formation of DLC film. Compared with the first embodiment, a film formation apparatus 100 used in the third embodiment includes a flow channel 114 instead of the flow channel 14. The flow channel 114 is provided with a tubular electric furnace 126 and a core tube 128 inserted through the tubular electric furnace 126.

In the third embodiment, a placement position 128s of a metallic film formation target 30 as an object on which diamond-like carbon film (DLC film) is to be formed is set at the position slightly downward of a central part 128c in the core tube 128. Accordingly, when the temperature inside the core tube 128 is raised, the temperature of the film formation target 30 is slightly lower than that of the central part 128c.

For forming a film on the film formation target 30 in the third embodiment, the film formation target 30 is placed at the placement position in the core tube 128. The placement position is set so that the film formation target 30 has a temperature of 600 to 650°C in the process of raising the temperature under the flow of the film formation gas in the case where the temperature of the central part 128c is set in a range suitable for removal of impurities from the surface of the film formation target 30 and film formation of DLC film by decomposition of the film formation gas RG.

In the third embodiment, compared with the first embodiment, the target temperature of the film formation target 30 can be reduced without lowering the target temperature of the film formation gas RG. This can extend the range of materials suitable for the film formation targets 30.

In the above description, the temperature of the film formation target 30 is in a range from 600 to 650°C. However, actually, even the temperature of the film formation target 30 of about 600 to 700°C can adequately provide the effect of extending the range of materials applicable to the film formation target 30. Moreover, the preferable range is from 610 to 650°C in the range from 600 to 650°C.

### <Experimental Example 8>

In Experimental Example 8, film formation was performed using the film formation apparatus 100 explained in the third embodiment. The core tube 128 was a cylindrical tube (diameter: 52 mm).

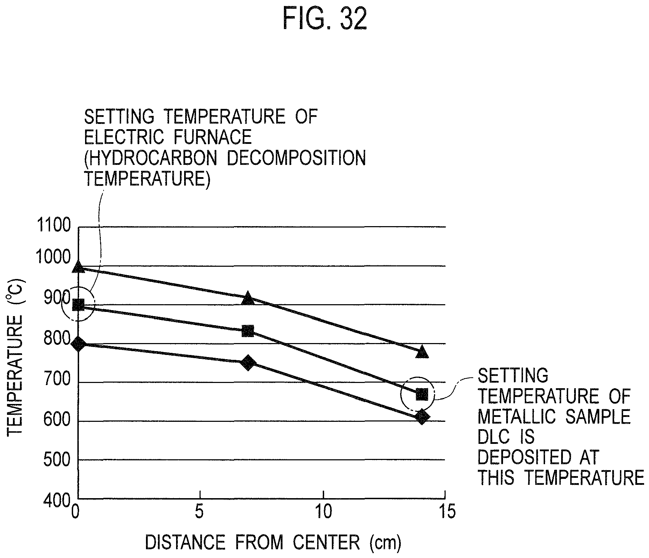

In Experimental Example 8, first, the relationship between the distance from the central part 128c of the electric furnace 126 on the downstream side and the temperature at the distance was obtained by experiments. The experimental results are shown in Fig. 32. In Experimental Example 8, the setting temperature of the electric furnace 126 means a setting temperature at the central part 128c, that is, a setting temperature at a position where the distance from the center is 0 cm in Fig. 32. The placement position 128s of the film formation target 30 was a position where the distance from the center is 14 mm on the downstream side. As can be seen from Fig. 32, the temperature of the placement position 128s was about 200°C lower than that of the central part 128c in any case.

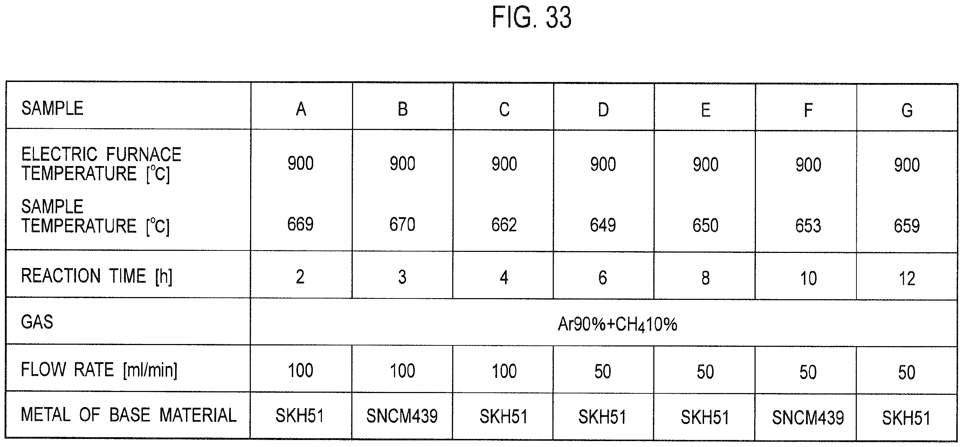

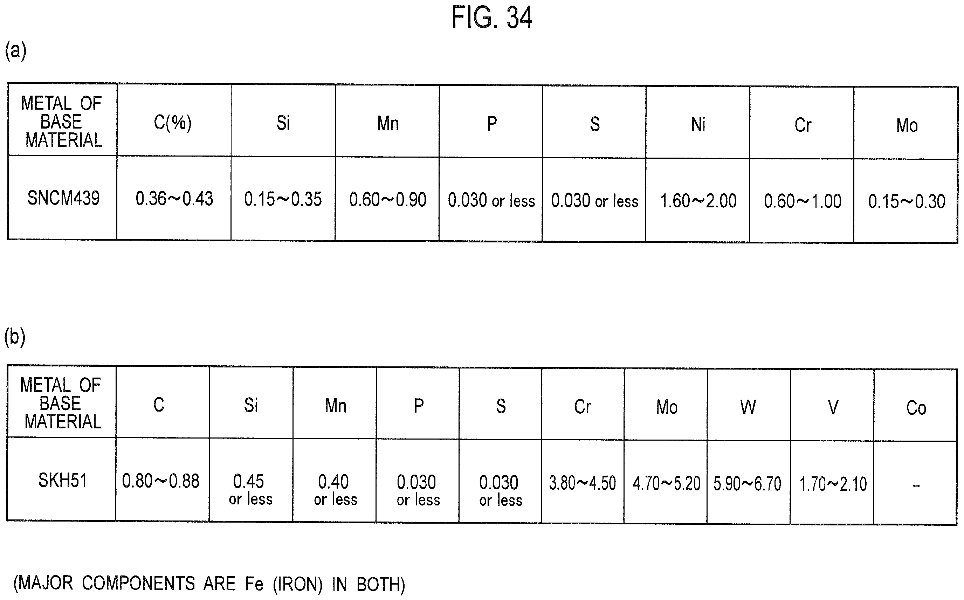

Furthermore, the inventor used seven types of plate samples A to G as the film formation target 30 and performs film formation on the surface of each sample (the film formation target surface 30f) with film formation conditions varied as parameters. The film formation conditions are shown in Fig. 33. Fig. 34(a) and Fig. 34(b) show the contents of the components of SKH51 and SNCM439 among the seven types of samples other than the major component (iron (Fe)).

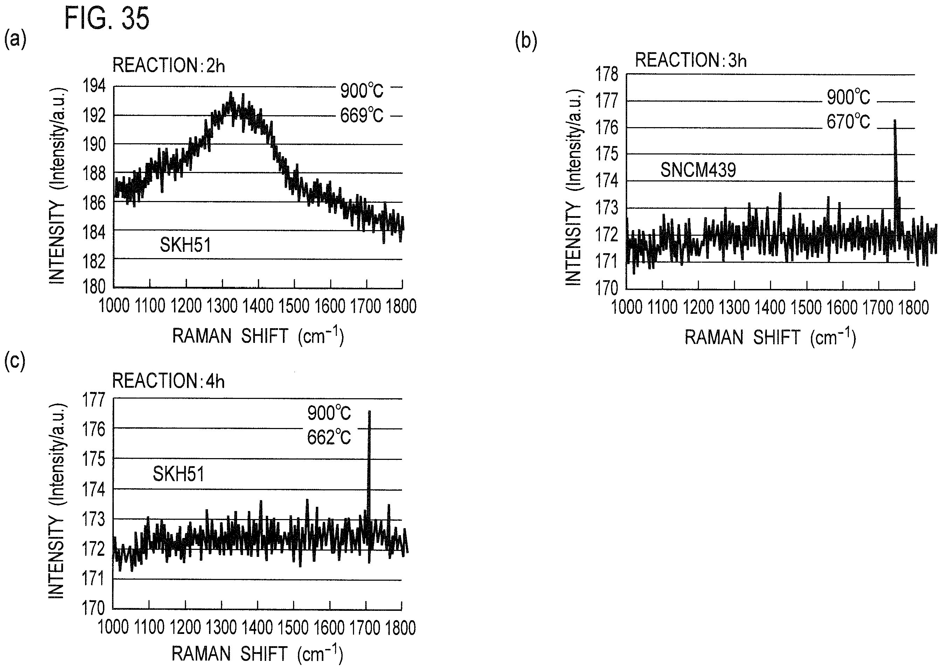

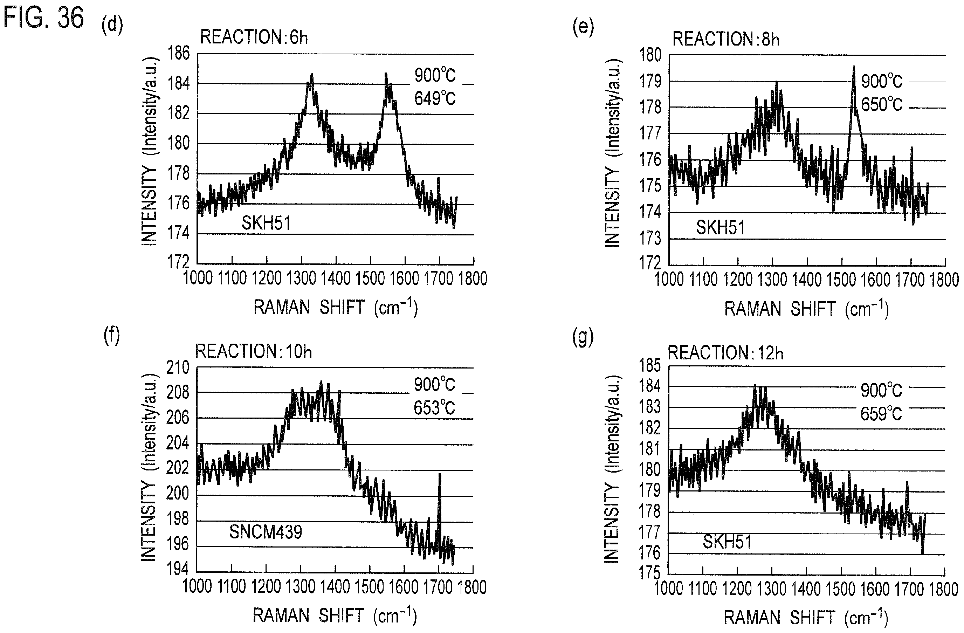

The film formed on each sample was analyzed with Raman spectroscopy. Figs. 35(a) to 35(c) and Figs. 36(d) to 36(g) show charts obtained by the spectroscopy. Figs. 35 (a) to 35(c) correspond to the charts obtained by spectroscopy for the samples A to C, respectively, and Figs. 36(d) to 36(g) correspond to the carts obtained by spectroscopy for the samples D to G, respectively. As described above, the formed film is evaluated to be DLC film based on the fact that the Raman spectrum thereof shows two broad signals around 1300 cm⁻¹ and 1600 cm⁻¹, that is, signals called the D and G peaks.

In Experimental Example 8, each film formed on the samples D and E (see Fig. 36(d) and 36(e), respectively) are determined to be a DLC film, and each film formed on the samples A to C, F, and G are determined to be not DLC film. Film formation on the sample D was performed at a sample temperature of 649°C with a reaction time (temperature holding time) of 6 hours, and film formation on the sample E was performed at a sample temperature of 649°C with a reaction time (temperature holding time) of 8 hours.

Based on Experimental Example 8 and the like, the formed film is thought to be a DLC film irrespective of the sample components when the temperature of the film formation target 30 is in a range from 600 to 650°C and the temperature holding time is in a range from 5 to 9 hours.

### INDUSTRIAL APPLICABILITY

As described above, the metal object with diamond-like carbon film according to the present disclosure is formed by placing a metallic film formation target in a flow channel through which film formation gas flows, raising the temperature of the film formation target to a predetermined temperature to remove impurities from the film formation target surface and cause the film formation gas to react with metallic elements exposed by the removal. Accordingly, the present invention is preferably applicable to a metal object with diamond-like carbon film including a diamond-like carbon film easily formed on metal and to a method of forming diamond-like carbon film.

### EXPLANATION OF REFERENTIAL NUMERALS

14 FLOW CHANNEL
30 FILM FORMATION TARGET
30f FILM FORMATION TARGET SURFACE
34 DLC FILM (DIAMOND-LIKE CARBON FILM)
36 METAL OBJECT WITH DLC FILM (METAL OBJECT WITH DIAMOND-LIKE CARBON FILM)
40 METALLIC TUBE (TUBE MATERIAL)
40f INNER SURFACE (TUBE MATERIAL INNER SURFACE)
44 DLC FILM (DIAMOND-LIKE CARBON FILM)
114 FLOW CHANNEL
RG FILM FORMATION GAS

## Claims

1. A method of forming a diamond-like carbon film (34), the method comprising:
a placement step of placing a metallic film formation target (30, 40), on which a diamond-like carbon film (34) is to be formed, in a flow channel (14) through which film formation gas containing methane gas and argon gas supplied from a gas source (12) is caused to flow;
the method being **characterized in that** it further comprises
an impurity removal/film formation step of forming the diamond-like carbon film (34) on a film formation target surface (30f, 40f) of the film formation target (30, 40) by causing the film formation gas from the gas source (12) to flow through the flow channel (14) at a predetermined flow rate during a process of raising the temperature of the film formation target (30, 40) from room temperature to a predetermined temperature to allow the film formation gas to react with impurities in the film formation target surface (30f, 40f) for removal of the impurities from the film formation target surface (30f, 40f) and further to allow the film formation gas to react with a metallic element exposed by the removal of the impurities,
wherein the method is carried out in a film formation apparatus comprising the gas source (12) including a methane gas source (18) and an argon gas source (20) ; the flow channel (14) provided with a furnace (26, 46); and a controller (16) controlling the gas source (12) and the flow channel (14), wherein the controller (16) includes a gas controller (22), which is configured to control the mixing ratio of the methane gas to the argon gas and regulate the flow rate of the film formation gas, and a temperature controller (24), which is configured to control the temperature of the film formation gas.

2. The method of forming a diamond-like carbon film (34) according to claim 1, wherein the film formation target (30, 40) is a tube material.

3. The method of forming a diamond-like carbon film (34) according to claim 2, wherein the diamond-like carbon film (34) is formed on a tube material inner surface as the film formation target surface (30f, 40f) by causing the film formation gas to flow through the tube material.

4. The method of forming a diamond-like carbon film (34) according to any one of claims 1 to 3, wherein the diamond-like carbon film (34) is formed by causing the film formation gas to flow while performing the process of raising the temperature of the film formation target (30, 40) from room temperature to the predetermined temperature after causing the film formation gas to flow at atmospheric pressure to replace gas in the flow channel (14) with the film formation gas.

5. The method of forming a diamond-like carbon film (34) according to any one of claims 1 to 4, wherein the diamond-like carbon film (34) is formed by using as the film formation gas, gas obtained by diluting methane gas with the argon gas to a predetermined concentration.

6. The method of forming a diamond-like carbon film (34) according to any one of claims 1 to 5, wherein an intermediate film rendering the diamond-like carbon film (34) resistant to separation is formed by raising the temperature of the film formation target (30, 40) from room temperature to the predetermined temperature before the diamond-like carbon film (34) is formed.

7. The method of forming a diamond-like carbon film (34) according to any one of claims 1 to 6, wherein the predetermined temperature is in a range from 400 to 900°C.

8. The method of forming a diamond-like carbon film (34) according to any one of claims 1 to 7, wherein in the process of raising the temperature at film formation of the diamond-like carbon film (34), the temperature of the film formation target (30, 40) is raised from room temperature to 800°C for 2 to 8 hours.

9. The method of forming a diamond-like carbon film (34) according to claim 8, wherein when the time period taken to raise the temperature from room temperature to 800°C is not less than 2 hours and less than 4 hours, the temperature is held at 800°C for 4 hours or more after the process of raising the temperature.

10. The method of forming a diamond-like carbon film (34) according to any one of claims 1 to 9, wherein the predetermined temperature is in a range from 600 to 650°C and the temperature is held for 5 to 9 hours after the process of raising the temperature.

11. The method of forming a diamond-like carbon film (34) according to any one of claims 1 to 10, wherein the diamond-like carbon film (34) is cooled to room temperature after methane gas is eliminated from the flow channel (14) by causing inert or nitrogen gas to flow through the flow channel (14) at the end of film formation.

## Patentansprüche

1. Verfahren zum Bilden eines diamantähnlichen Kohlenstofffilms (34), wobei das Verfahren umfasst:
einen Platzierungsschritt, bei dem ein metallisches Filmbildungstarget (30, 40), auf dem ein diamantähnlicher Kohlenstofffilm (34) zu bilden ist, in einen Strömungskanal (14) platziert wird, durch den man ein aus einer Gasquelle (12) zugeführtes Methangas und Argongas enthaltendes Filmbildungsgas fließen lässt;
wobei das Verfahren **dadurch gekennzeichnet ist, dass** es weiterhin umfasst
einen Verunreinigungsentfernungs-/Filmbildungsschritt, bei dem der diamantähnliche Kohlenstofffilm (34) auf einer Filmbildungstargetfläche (30f, 40f) des Filmbildungstargets (30, 40) gebildet wird, indem man das Filmbildungsgas aus der Gasquelle (12) durch den Strömungskanal (14) bei einer vorgegebenen Durchflussrate während eines Vorgangs fließen lässt, bei dem die Temperatur des Filmbildungstargets (30, 40) von Raumtemperatur auf eine vorgegebene Temperatur erhöht wird, so dass das Filmbildungsgas mit Verunreinigungen in der Filmbildungstargetfläche (30f, 40f) reagieren kann, um die Verunreinigungen aus der Filmbildungstargetfläche (30f, 40f) zu entfernen und weiterhin das Reagieren des Filmbildungsgases mit einem durch die Entfernung der Verunreinigungen exponierten metallischen Element zu ermöglichen,
wobei das Verfahren in einer Filmbildungsvorrichtung durchgeführt wird, umfassend die Gasquelle (12) einschließlich einer Methangasquelle (18) und einer Argongasquelle (20); den Strömungskanal (14), ausgestattet mit einem Ofen (26, 46); und einen Regler (16), der die Gasquelle (12) und den Strömungskanal (14) kontrolliert, wobei der Regler (16) einen Gasregler (22), der zum Kontrollieren des Mischungsverhältnisses des Methangases zum Argongas und zum Regulieren der Durchflussrate des Filmbildungsgases ausgestaltet ist, und einen Temperaturregler (24), der zum Kontrollieren der Temperatur des Filmbildungsgases ausgestaltet ist, umfasst.

2. Verfahren zum Bilden eines diamantähnlichen Kohlenstofffilms (34) gemäß Anspruch 1, wobei das Filmbildungstarget (30, 40) ein Röhrenmaterial ist.

3. Verfahren zum Bilden eines diamantähnlichen Kohlenstofffilms (34) gemäß Anspruch 2, wobei der diamantähnliche Kohlenstofffilm (34) auf einer Röhrenmaterialinnenfläche als die Filmbildungstargetfläche (30f, 40f) gebildet wird, indem man das Filmbildungsgas durch das Röhrenmaterial fließen lässt.

4. Verfahren zum Bilden eines diamantähnlichen Kohlenstofffilms (34) gemäß einem der Ansprüche 1 bis 3, wobei der diamantähnliche Kohlenstofffilm (34) gebildet wird, indem man das Filmbildungsgas fließen lässt, während ein Vorgang durchgeführt wird, bei dem die Temperatur des Filmbildungstargets (30, 40) von Raumtemperatur auf eine vorgegebene Temperatur erhöht wird nachdem man das Filmbildungsgas bei atmosphärischem Druck fließen lassen hat, so dass das Gas in dem Strömungskanal (14) durch das Filmbildungsgas ersetzt wird.

5. Verfahren zum Bilden eines diamantähnlichen Kohlenstofffilms (34) gemäß einem der Ansprüche 1 bis 4, wobei der diamantähnliche Kohlenstofffilm (34) gebildet wird, indem ein durch Verdünnen von Methangas mit dem Argongas bis zu einer vorgegebenen Konzentration erhaltenes Gas als das Filmbildungsgas verwendet wird.

6. Verfahren zum Bilden eines diamantähnlichen Kohlenstofffilms (34) gemäß einem der Ansprüche 1 bis 5, wobei ein intermediärer Film, der dem diamantähnlichen Kohlenstofffilm (34) Separationswiderstand verleiht, gebildet wird, indem die Temperatur des Filmbildungstargets (30, 40) auf eine vorgegebene Temperatur erhöht wird bevor der diamantähnliche Kohlenstofffilms (34) gebildet wird.

7. Verfahren zum Bilden eines diamantähnlichen Kohlenstofffilms (34) gemäß einem der Ansprüche 1 bis 6, wobei die vorgegebene Temperatur in einem Bereich von 400 bis 900°C liegt.

8. Verfahren zum Bilden eines diamantähnlichen Kohlenstofffilms (34) gemäß einem der Ansprüche 1 bis 7, wobei in dem Vorgang, bei dem die Temperatur bei Filmbildung des diamantähnlichen Kohlenstofffilms (34) erhöht wird, die Temperatur des Filmbildungstargets (30, 40) von Raumtemperatur auf 800°C während 2 bis 8 Stunden erhöht wird.

9. Verfahren zum Bilden eines diamantähnlichen Kohlenstofffilms (34) gemäß Anspruch 8, wobei wenn die Zeitdauer zum Erhöhen der Temperatur von Raumtemperatur auf 800°C nicht weniger als 2 Stunden und weniger als 4 Stunden beträgt, die Temperatur bei 800°C während 4 Stunden oder mehr nach dem Vorgang des Erhöhens der Temperatur gehalten wird.

10. Verfahren zum Bilden eines diamantähnlichen Kohlenstofffilms (34) gemäß einem der Ansprüche 1 bis 9, wobei die vorgegebene Temperatur in einem Bereich von 600 bis 650°C liegt und die Temperatur während 5 bis 9 Stunden nach dem Vorgang des Erhöhens der Temperatur gehalten wird.

11. Verfahren zum Bilden eines diamantähnlichen Kohlenstofffilms (34) gemäß einem der Ansprüche 1 bis 10, wobei der diamantähnliche Kohlenstofffilm (34) auf Raumtemperatur gekühlt wird nachdem das Methangas aus dem Strömungskanal (14) eliminiert wird, indem man Inert- oder Stickstoffgas durch den Strömungskanal (14) (14) am Ende der Filmbildung fließen lässt.

## Revendications

1. Procédé de formation d'un film de carbone de type diamant (34), le procédé comprenant:
une étape de placement consistant à placer une cible de formation de film métallique (30, 40), sur laquelle un film de carbone de type diamant (34) doit être formé, dans un canal d'écoulement (14) à travers lequel un gaz de formation de film contenant du gaz méthane et du gaz argon alimenté par une source de gaz (12) est amené à s'écouler;
le procédé étant **caractérisé en ce qu'**il comprend en outre
une étape d'élimination d'impuretés/de formation de film où le film de carbone de type diamant (34) est formé sur une surface cible de formation de film (30f, 40f) de la cible de formation de film (30, 40) en amenant le gaz de formation de film provenant de la source de gaz (12) à s'écouler à travers le canal d'écoulement (14) à un débit d'écoulement prédéterminé pendant un processus d'augmentation de la température de la cible de formation de film (30, 40) de la température ambiante jusqu'à une température prédéterminée pour permettre au gaz de formation de film de réagir avec des impuretés dans la surface cible de formation de film (30f, 40f) pour éliminer les impuretés de la surface cible de formation de film (30f, 40f) et pour permettre en outre au gaz de formation de film de réagir avec un élément métallique exposé par l'élimination des impuretés,
dans lequel le procédé est mis en oeuvre dans un appareil de formation de film comprenant la source de gaz (12) incluant une source de gaz méthane (18) et une source de gaz argon (20) ; le canal d'écoulement (14) pourvu d'un four (26, 46) ; et un dispositif de commande (16) commandant la source de gaz (12) et le canal d'écoulement (14), dans lequel le dispositif de commande (16) comprend un dispositif de commande de gaz (22) qui est configuré pour commander le ratio de mélange du gaz méthane par rapport gaz argon et réguler le débit d'écoulement du gaz de formation de film, et un dispositif de commande de température (24), qui est configuré pour commander la température du gaz de formation de film.

2. Procédé de formation d'un film de carbone de type diamant (34) selon la revendication 1, dans lequel la cible de formation de film (30, 40) est un matériau tubulaire.

3. Procédé de formation d'un film de carbone de type diamant (34) selon la revendication 2, dans lequel le film de carbone de type diamant (34) est formé sur une surface interne de matériau tubulaire en tant que surface cible de formation de film (30f, 40f) en amenant le gaz de formation de film à s'écouler à travers le matériau tubulaire.

4. Procédé de formation d'un film de carbone de type diamant (34) selon l'une quelconque des revendications 1 à 3, dans lequel le film de carbone de type diamant (34) est formé en amenant le gaz de formation de film à s'écouler tout en effectuant le processus d'augmentation de la température de la cible de formation de film (30, 40) de la température ambiante jusqu'à la température prédéterminée après avoir amené le gaz de formation de film à s'écouler à pression atmosphérique pour remplacer le gaz dans le canal d'écoulement (14) par le gaz de formation de film.

5. Procédé de formation d'un film de carbone de type diamant (34) selon l'une quelconque des revendications 1 à 4, dans lequel le film de carbone de type diamant (34) est formé en utilisant comme gaz de formation de film le gaz obtenu en diluant du gaz méthane avec le gaz argon à une concentration prédéterminée.

6. Procédé de formation d'un film de carbone de type diamant (34) selon l'une quelconque des revendications 1 à 5, dans lequel un film intermédiaire rendant le film de carbone de type diamant (34) résistant à la séparation est formé en augmentant la température de la cible de formation de film (30, 40) de la température ambiante jusqu'à la température prédéterminée avant la formation du film de carbone de type diamant (34).

7. Procédé de formation d'un film de carbone de type diamant (34) selon l'une quelconque des revendications 1 à 6, dans lequel la température prédéterminée se situe dans la plage allant de 400 à 900°C.

8. Procédé de formation d'un film de carbone de type diamant (34) selon l'une quelconque des revendications 1 à 7, dans lequel, dans le processus d'augmentation de la température lors de la formation de film du film de carbone de type diamant (34), la température de la cible de formation de film (30, 40) est augmentée de la température ambiante jusqu'à 800°C pendant 2 à 8 heures.

9. Procédé de formation d'un film de carbone de type diamant (34) selon la revendication 8, dans lequel lorsque la durée prise pour augmenter la température de la température ambiante jusqu'à 800°C n'est pas inférieure à 2 heures et inférieure à 4 heures, la température est maintenue à 800°C pendant 4 heures ou plus après le processus d'augmentation de la température.

10. Procédé de formation d'un film de carbone de type diamant (34) selon l'une quelconque des revendications 1 à 9, dans lequel la température prédéterminée se situe dans une plage allant de 600 à 650°C et la température est maintenue pendant 5 à 9 heures après le processus d'augmentation de la température.

11. Procédé de formation d'un film de carbone de type diamant (34) selon l'une quelconque des revendications 1 à 10, dans lequel le film de carbone de type diamant (34) est refroidi jusqu'à température ambiante après élimination du gaz méthane à partir du canal d'écoulement (14) en amenant un gaz inerte ou de l'azote gazeux à s'écouler à travers le canal d'écoulement (14) à la fin de la formation de film.
